# EUROPEAN PATENT APPLICATION

(11) **EP 4 597 569 A1**
(43) Date of publication of application: **06.08.2025**
(21) Application number: 23873291.1
(22) Date of filing: 04.10.2023
(51) Int. Cl.: H01L 23/498, H01L 23/538, H01L 25/065

(54) **CIRCUIT BOARD, AND SEMICONDUCTOR PACKAGE COMPRISING SAME**

(30) Priority: 29.09.2022 KR 20220124577
(71) Applicant: LG INNOTEK CO. LTD, Gangseo-gu Seoul 07796 (KR)
(72) Inventor: JUNG, Won Suk, Seoul 07796 (KR)
(74) Representative: Plasseraud IP
(86) International application number: PCT/KR2023/015217
(87) International publication number: WO 2024/072184

(57) **Abstract**

A circuit board according to an embodiment includes a build-up insulating layer; a connection member embedded in the build-up insulating layer; and an insulating member disposed on one surface of the connection member, wherein the connection member includes: a first insulating layer; and a second insulating layer disposed on the first insulating layer, wherein the first insulating layer, the second insulating layer, and the insulating member includes different insulating materials, and wherein a side surface of the first insulating layer, a side surface of the second insulating layer, and a side surface of the insulating member have a step.

## Description

### [Technical Field]

An embodiment relates to a circuit board, and more particularly to a circuit board having improved bonding strength with a connection member and a semiconductor package including the same..

### [Background Art]

As performances of electric/electronic products progresses, technologies for disposing a greater number of semiconductor devices on a semiconductor package circuit board of a limited size are being proposed and studied. However, since a general semiconductor package is based on mounting a single semiconductor device, there is a limit to obtaining a desired performance.

Accordingly, a semiconductor package that mounts a plurality of semiconductor devices using a plurality of circuit boards has been recently provided. This semiconductor package has a structure in which a plurality of semiconductor devices are connected to each other in a horizontal direction and/or a vertical direction on the circuit board. Accordingly, the semiconductor package has the advantage of efficiently using a mounting area of the semiconductor devices and transmitting highspeed signals through a short signal transmission path between the semiconductor devices.

Due to these advantages, the semiconductor package as described above is widely applied to mobile devices, etc.

In addition, semiconductor packages applied to products that provide the Internet of Things (IoT), autonomous vehicles, and high-performance servers are expanding a concept to semiconductor chiplets as a number of semiconductor devices and/or a size of each semiconductor device increases in accordance with a trend of high integration, or as functional parts of the semiconductor devices are divided.

Accordingly, an intercommunication between semiconductor devices and/or semiconductor chiplets is becoming important, and accordingly, there is a trend to dispose an interposer between the circuit board of the semiconductor package and the semiconductor devices.

An interposer can function as a redistribution layer that gradually increases a width or depth of a circuit pattern from the semiconductor device to the semiconductor package in order to facilitate the intercommunication between the semiconductor devices and/or semiconductor chiplets, or to interconnect the semiconductor devices and the semiconductor package circuit board, thereby smoothly transmitting electrical signals between the semiconductor device and the semiconductor package circuit board having a relatively large circuit pattern compared to the circuit pattern of the semiconductor device.

Meanwhile, a package circuit board and/or interposer applied to a semiconductor package is provided with a connection member connected to a semiconductor device and/or a semiconductor chip-let. The connection member functions to horizontally connect a plurality of semiconductor devices and/or semiconductor chip-lets. Accordingly, the connection member may be embedded in the package circuit board and/or interposer.

At this time, the connection member may be an inorganic bridge. For example, in a prior art, the inorganic bridge applied to a semiconductor package may be a silicon bridge. Accordingly, a semiconductor package according to the prior art has a limitation in reducing a size of the connection member of the silicon bridge, and thus has a limitation in reducing an overall size of the semiconductor package.

In addition, the silicon bridge has a problem of being vulnerable to mechanical reliability. That is, a build-up insulating layer included in a package circuit board and/or interposer includes an insulating material different from the connection member of the silicon bridge. As a result, stress may be concentrated on the connection member due to a difference in thermal characteristics between the build-up insulating layer of the prior art and the connection member. In addition, there is a problem that cracks occur in the connection member due to the concentrated stress.

### [Disclosure]

### [Technical Problem]

An embodiment provides a circuit board with a connection member embedded therein and a semiconductor package including the same.

In addition, the embodiment provides a semiconductor package capable of improving adhesion between the connection member and the build-up insulating layer.

In addition, the embodiment provides a semiconductor package having a connection member embedded therein, the connection member including a stepped portion provided in a horizontal direction.

In addition, the embodiment provides a semiconductor package including a step portion provided along a vertical direction in a build-up insulating layer.

In addition, the embodiment provides a semiconductor package including a step portion provided along a vertical direction in an electrode part.

In addition, the embodiment provides a semiconductor package capable of recognizing mounting positions of a plurality of semiconductor devices.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A circuit board according to an embodiment comprises a build-up insulating layer; a connection member embedded in the build-up insulating layer; and an insulating member disposed on one surface of the connection member, wherein the connection member includes: a first insulating layer; and a second insulating layer disposed on the first insulating layer, wherein the first insulating layer, the second insulating layer, and the insulating member includes different insulating materials, and wherein a side surface of the first insulating layer, a side surface of the second insulating layer, and a side surface of the insulating member have a step.

In addition, the connection member further includes a third insulating layer disposed on the second insulating layer, and the third insulating layer includes an insulating material different from that of at least one of the first and second insulating layers, and a side surface of the third insulating layer has a step from a side surface of the first insulating layer, a side surface of the second insulating layer, and a side surface of the insulating member.

In addition, a width in a horizontal direction of the first insulating layer of the connection member is greater than a width in the horizontal direction of the second insulating layer.

In addition, a width in the horizontal direction of the insulating member is greater than a width in the horizontal direction of each of the first insulating layer and the second insulating layer.

In addition, the first insulating layer of the connection member includes a polyimide.

In addition, the second insulating layer of the connection member includes a resin layer including a filler.

In addition, the build-up insulating layer includes an insulating material different from that of the second insulating layer of the connection member.

In addition, the build-up insulating layer includes a same insulating material as the second insulating layer of the connection member, and a diameter of a filler provided in the build-up insulating layer is different from a diameter of a filler provided in the second insulating layer of the connection member.

In addition, the diameter of the filler provided in the build-up insulating layer is greater than the diameter of the filler provided in the second insulating layer of the connection member.

In addition, a horizontal distance from an outermost end to an innermost end of the connection member satisfies a range of 50 µm to 70 µm.

In addition, the build-up insulating layer includes a portion having a step in the vertical direction.

In addition, an upper surface of the build-up insulating layer includes a first upper surface vertically overlapping the connection member and a second upper surface not vertically overlapping the connection member, and a height of the first upper surface is different from a height of the second upper surface.

In addition, the circuit board further comprises an electrode part penetrating from an upper surface of the build-up insulating layer to a partial region of the build-up insulating layer, and the electrode part includes a first electrode part vertically overlapping the connection member; and a second electrode part not vertically overlapping the connection member, and an upper surface of the first electrode part has a step from an upper surface of the second electrode part.

In addition, the build-up insulating layer includes a first layer; and a second layer on the first layer, and the first electrode part and the second electrode part include a first protruding electrode disposed on the first electrode part and penetrating from the upper surface of the first layer to a partial region of the first layer; and a second protruding electrode disposed on the second electrode part.

In addition, the plurality of first protruding electrodes include first protruding electrodes of a first group and first protruding electrodes of a second group, and the plurality of second protruding electrodes include second protruding electrodes of a first group and second protruding electrodes of a second group, and wherein the circuit board further includes a first semiconductor device disposed on the first protruding electrodes of the first group and the second protruding electrodes of the first group; and a second semiconductor device disposed on the second protruding electrodes of the second group and the second protruding electrodes of the second group.

In addition, the semiconductor package further comprises at least one third semiconductor device embedded in the build-up insulating layer, and the third semiconductor device does not vertically overlap with the connection member.

In addition, each of the first and second protruding electrodes includes a first metal layer; and a second metal layer disposed on the first metal layer and including a metal material different from that of the first metal layer, and the first metal layer includes a convex portion toward a lower surface of the build-up insulating layer.

### [Advantageous Effects]

The semiconductor package of the embodiment may include a build-up insulating layer and a connection member embedded in the build-up insulating layer. In addition, a side surface of the connection member may have a step. For example, the connection member may include a plurality of insulating layers including different insulating materials. In addition, a side surface of the plurality of insulating layers may have a step. In addition, the side surface of the connection member having the step may contact the build-up insulating layer. Through this, a contact area between the build-up insulating layer and the connection member may be improved. Through this, a problem of the connection member being peeled off from the first insulating layer may be solved.

Meanwhile, the connection member may include an organic material having a similar coefficient of thermal expansion to the build-up insulating layer. Through this, the embodiment may minimize stress applied to the connection member. Furthermore, the embodiment may solve a problem of cracks occurring in the connection member or of the connection member being peeled off from the circuit board. Through this, the embodiment may improve mechanical reliability and electrical reliability of the semiconductor package.

In addition, the embodiment can reduce a cost of the connection member by changing the first insulating layer of the connection member to polyimide, which is cheaper than silicon.

In addition, the connection member can be equipped with small-width via electrodes. In addition, an alignment state between the plurality of via electrodes equipped in different layers can have a great influence on operating characteristics of the connection member, operating characteristics of the semiconductor package, and operating characteristics of the electronic product or server to which the semiconductor package is applied. At this time, the polyimide can have transparent characteristics. Accordingly, the embodiment can improve the alignment state of the plurality of via electrodes disposed in different layers. Through this, the operating characteristics of the connection member, the operating characteristics of the semiconductor package, and the operating characteristics of the electronic product or server to which the semiconductor package is applied can be further improved.

In addition, since the first insulating layer of the connection member has a similar coefficient of thermal expansion to the build-up insulating layer, the connection member can be allowed to flow together with the circuit board when the circuit board is thermally deformed. Through this, the embodiment can solve the problem of cracking of the connection member that may occur due to thermal deformation of the circuit board.

Meanwhile, the connection member can include a third insulating layer of solder resist. In addition, the third insulating layer can be easily broken during a sawing process of the connection member. Therefore, the embodiment can safely protect the third insulating layer from an impact by making a width of the third insulating layer smaller than a width of other insulating layers. Through this, the embodiment can further improve product reliability.

Meanwhile, an upper surface of the build-up insulating layer of the embodiment can have a step, and further, upper surfaces of the first protruding electrode and the second protruding electrode can also have a step. In addition, since the first protruding electrode and the second protruding electrode have a step, arrangement positions of a first semiconductor device and a second semiconductor device can be recognized, and through this, the first and second semiconductor devices can be mounted at more accurate positions. Furthermore, the embodiment can adjust a volume of a conductive bonding member, such as solder, which is disposed on the first protruding electrode and the second protruding electrode differently from each other. Therefore, the embodiment can make the protruding electrode, on which the conductive bonding member requiring a larger volume is disposed, be positioned lower than the other protruding electrode. This can be possible by adjusting a difference in a thickness of a cavity and the connection member. Through this, the embodiment can make the semiconductor device more stably coupled to the circuit board. Therefore, the embodiment can make the semiconductor device operate smoothly, and further can improve the operating characteristics of electronic products and/or servers to which the semiconductor package is applied.

In addition, the first protruding electrode and the second protruding electrode can each include a first metal layer and a second metal layer. The first metal layer can include nickel. In addition, the second metal layer can include copper. The first metal layer can improve a bonding strength between the second metal layer and the electrode part. For example, when the second metal layer is directly disposed on the electrode part, oxidation of the electrode part may occur, which may reduce the bonding strength between the electrode part and the protruding electrode. Therefore, the first metal layer may function to prevent oxidation of the first electrode part while improving the bonding strength between the second metal layer and the first electrode part. In addition, the first metal layer may solve a problem of the protruding electrode being peeled off from the electrode part due to contraction and expansion of the second insulating layer caused by thermal stress.

Specifically, when the first metal layer includes nickel, the adhesion between the electrode part and the protruding electrode may be improved. In addition, when electrically connecting the protruding electrode with a material such as solder is formed later, the solder may diffuse into the electrode part to form an inter-metallic compound, and the inter-metallic compound has a problem of reduced mechanical and electrical reliability. In particular, when the second metal layer is made of copper, the problem of forming an inter-metallic compound may be further aggravated, but when nickel is disposed, diffusion of solder can be prevented, thereby preventing a formation of an inter-metallic compound, thereby improving the electrical and mechanical reliability of the semiconductor package.

### [Description of Drawings]

FIG. 1a is a cross-sectional view showing a semiconductor package according to a first embodiment.
FIG. 1b is a cross-sectional view showing a semiconductor package according to a second embodiment.
FIG. 1c is a cross-sectional view showing a semiconductor package according to a third embodiment.
FIG. 1d is a cross-sectional view showing a semiconductor package according to a fourth embodiment.
FIG. 1e is a cross-sectional view showing a semiconductor package according to a fifth embodiment.
FIG. 2 is a cross-sectional view showing a circuit board according to a first embodiment.
FIG. 3 is a cross-sectional view showing a circuit board according to a second embodiment.
FIG. 4 is a plan view of a circuit board of FIG. 2 viewed from an upward direction.
FIG. 5 is a cross-sectional view showing a state in which a plurality of semiconductor devices are coupled to a circuit board of FIG. 3.
FIG. 6 is a cross-sectional view showing a detailed layer structure of the connection member of FIG. 2.
FIG. 7 is a plan view of the connection member of FIG. 6 viewed from an upward direction.
FIG. 8 is an enlarged cross-sectional view of a partial region of the circuit board of FIG. 3 according to a first embodiment.
FIG. 9 is a drawing for explaining an interface between a build-up insulating layer and a connection member of FIG. 8.
FIG. 10 is a cross-sectional view showing a detailed layer structure of a protruding electrode of an embodiment.
FIG. 11 is an enlarged cross-sectional view of a partial region of a circuit board of FIG. 3 according to a second embodiment.
FIG. 12 is an enlarged cross-sectional view of a partial region of the circuit board of FIG. 3 according to a third embodiment.

### [Best Mode]

Hereinafter, exemplary embodiments of the present invention will be described in detail with reference to the accompanying drawings, wherein like reference numerals are used to designate identical or similar elements, and redundant description thereof will be omitted. The suffix "module" and "portion" of the components used in the following description are only given or mixed in consideration of ease of preparation of the description, and there is no meaning or role to be distinguished as it is from one another. Also, in the following description of the embodiments of the present invention, a detailed description of related arts will be omitted when it is determined that the gist of the embodiments disclosed herein may be obscured. Also, the accompanying drawings are included to provide a further understanding of the invention, are incorporated in, and constitute a part of this description, and it should be understood that the invention is intended to cover all modifications, equivalents, or alternatives falling within the spirit and scope of the invention.

Terms including ordinals, such as first, second, etc., may be used to describe various components, but the elements are not limited to these terms. The terms are used only for distinguishing one component from another.

When a component is referred to as being "connected" or "contacted" to another component, it may be directly connected or joined to the other component, but it should be understood that other component may be present therebetween. When a component is referred to as being "directly connected" or "directly contacted" to another component, it should be understood that other component may not be present therebetween.

A singular representation includes plural representations, unless the context clearly implies otherwise.

In the present application, terms such as "including" or "having" are used to specify the presence of features, numbers, steps, operations, components, parts, or combinations thereof described in the description. However, it should be understood that the terms do not preclude the presence or addition of one or more other features, numbers, steps, operations, components, parts, or combinations thereof.

Hereinafter, embodiments of a present invention will be described in detail with reference to attached drawings.

### -Electronic device-

Before describing the embodiment, an electronic device to which the semiconductor package of the embodiment is applied will be briefly described. The electronic device includes a main board (not shown). The main board may be physically and/or electrically connected to various components. For example, the main board may be connected to the semiconductor package of the embodiment. Various semiconductor devices may be mounted on the semiconductor package.

The semiconductor device may include an active device and/or a passive device. The active device may be a semiconductor chip in the form of an integrated circuit (IC) in which hundreds to millions of devices are integrated in one semiconductor device. The semiconductor device may be a logic chip, a memory chip, or the like. The logic chip may be a central processor (CPU), a graphics processor (GPU), or the like. For example, the logic chip may be an application processor (AP) chip including at least one of a central processor (CPU), a graphics processor (GPU), a digital signal processor, a cryptographic processor, a microprocessor and a microcontroller, or an analog-digital converter, an application-specific IC (ASIC), or the like, or a chip set comprising a specific combination of those listed so far.

The memory chip may be a stack memory such as HBM. The memory chip may also include a memory chip such as volatile memory (e.g., DRAM), non-volatile memory (e.g., ROM), flash memory, and the like.

On the other hand, a product group to which the semiconductor package of the embodiment is applied may be any one of CSP (Chip Scale Package), FC-CSP (Flip Chip-Chip Scale Package), FC-BGA (Flip Chip Ball Grid Array), POP (Package on Package) and SIP (System in Package), but is not limited thereto.

In addition, the electronic device may be a smart phone, a personal digital assistant, a digital video camera, a digital still camera, a vehicle, a high-performance server, a network system, computer, monitor, tablet, laptop, netbook, television, video game, smart watch, automotive, or the like. However, the embodiment is not limited thereto, and may be any other electronic device that processes data in addition to these.

Hereinafter, a semiconductor package including a circuit board according to an embodiment will be described. The semiconductor package of the embodiment may have various package structures including a circuit board to be described later.

In addition, the circuit board in one embodiment may be a first circuit board described below.

In addition, the circuit board in another embodiment may be a second circuit board described below.

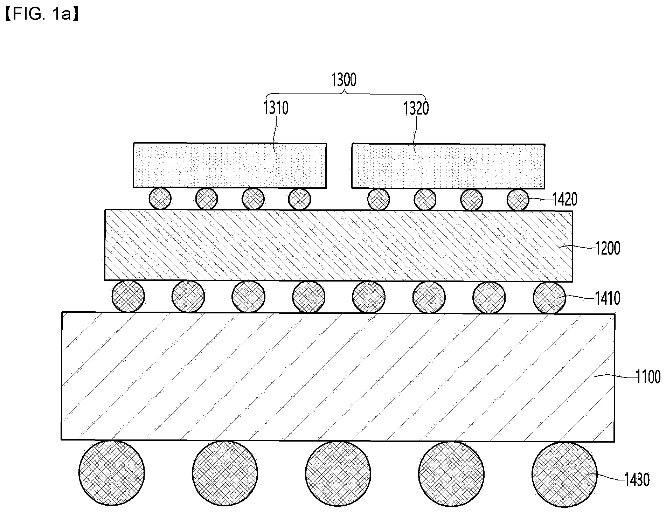

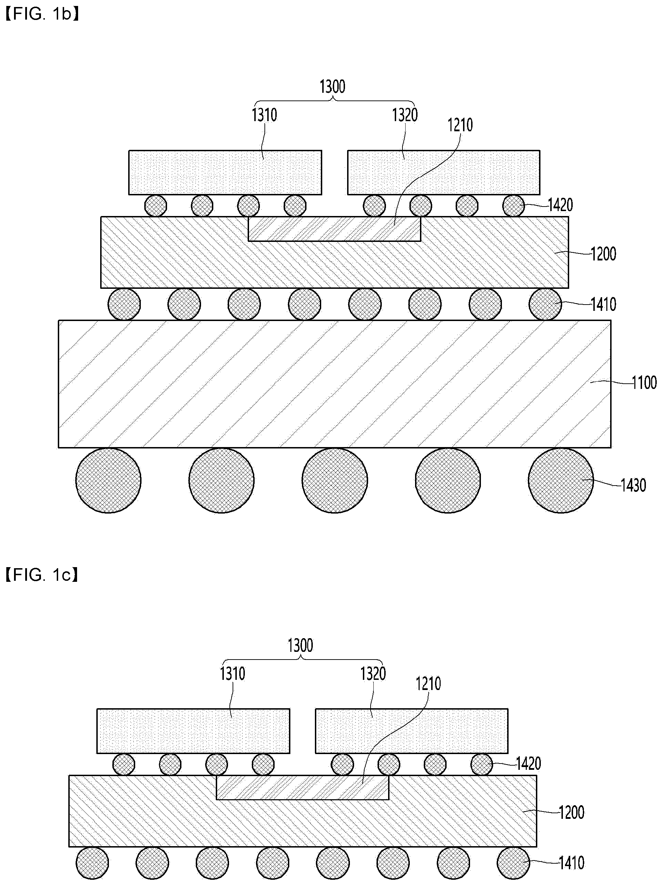

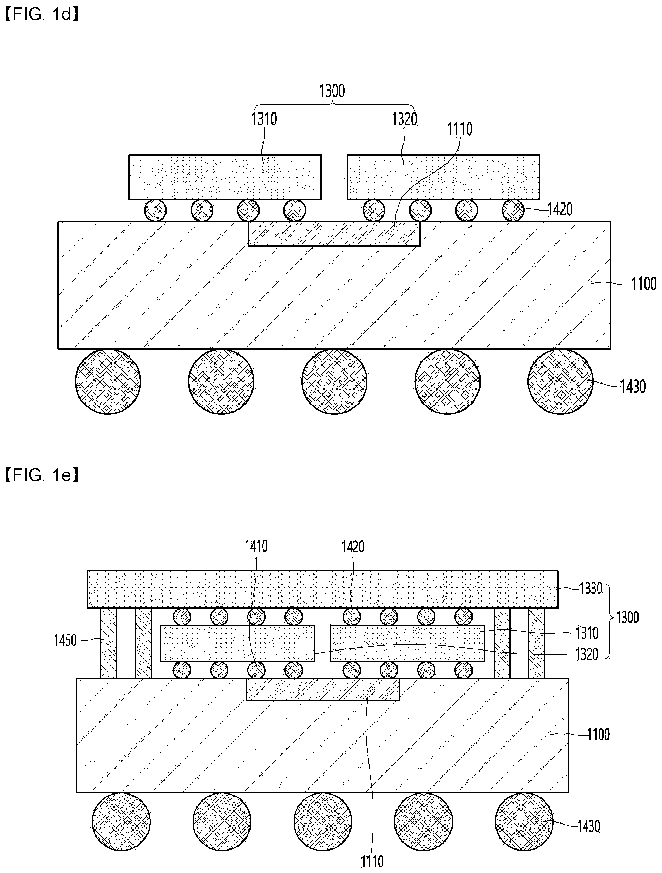

FIG. 1a is a cross-sectional view showing a semiconductor package according to a first embodiment, FIG. 1b is a cross-sectional view showing a semiconductor package according to a second embodiment, FIG. 1c is a cross-sectional view showing a semiconductor package according to a third embodiment, FIG. 1d is a cross-sectional view showing a semiconductor package according to a fourth embodiment, and FIG. 1e is a cross-sectional view showing a semiconductor package according to a fifth embodiment.

Referring to FIG. 1a, the semiconductor package according to the first embodiment may include a first circuit board 1100, a second circuit board 1200, and a semiconductor device 1300.

The first circuit board 1100 may mean a package circuit board.

For example, the first circuit board 1100 may provide a space to which at least one external circuit board is coupled. The external circuit board may refer to a second circuit board 1200 coupled to the first circuit board 1100. Also, the external circuit board may refer to a main board included in an electronic device coupled to a lower portion of the first circuit board 1100.

Also, although not shown in the drawing, the first circuit board 1100 may provide a space in which at least one semiconductor device is mounted.

The first circuit board 1100 may include at least one insulating layer, an electrode part disposed on the at least one insulating layer.

A second circuit board 1200 may be disposed on the first circuit board 1100.

The second circuit board 1200 may be an interposer. For example, the second circuit board 1200 may provide a space in which at least one semiconductor device is mounted. The second circuit board 1200 may be connected to the at least one semiconductor device 1300. For example, the second circuit board 1200 may provide a space in which the first semiconductor device 1310 and the second semiconductor device 1320 are mounted. The second circuit board 1200 may electrically connect the first and second semiconductor devices 1310 and 1320 and the first circuit board 1100 while electrically connecting the first semiconductor device 1310 and the second semiconductor device 1320. That is, the second circuit board 1200 may perform a horizontal connection function between a plurality of semiconductor devices and a vertical connection function between the semiconductor devices and the package circuit board.

FIG. 1a illustrates that the first and second semiconductor devices 1310 and 1320 are disposed on the second circuit board 1200, but is not limited thereto. For example, one semiconductor device may be disposed on the second circuit board 1200, or alternatively, three or more semiconductor devices may be disposed.

The second circuit board 1200 may be disposed between at least one semiconductor device 1300 and the first circuit board 1100.

In an embodiment, the second circuit board 1200 may be an active interposer that functions as a semiconductor device. When the second circuit board 1200 functions as a semiconductor device, the semiconductor package of the embodiment may have a structure that is vertically stacked on the first circuit board 1100 and may have functions of multiple logic chips. Having the function of a logic chip may mean that it may have functions of an active device and a passive device. In a case of an active device, characteristics of current and voltage may not be linear unlike a passive device, and in a case of an active interposer, it may have the function of an active device. In addition, the active interposer may perform a function of a corresponding logic chip while performing a signal transmission function between a second logic chip disposed thereon and the first circuit board 1100.

According to another embodiment, the second circuit board 1200 may be a passive interposer. For example, the second circuit board 1200 may function as a signal relay between the semiconductor device 1300 and the first circuit board 1100, and can have a passive device function such as a resistor, capacitor, or inductor. For example, a number of terminals of the semiconductor device 1300 is gradually increasing due to 5G, Internet of Things (IOT), increased image quality, and increased communication speed. That is, the number of terminals provided in the semiconductor device 1300 increases, thereby reducing the width of the terminals or an interval between the plurality of terminals. In this case, the first circuit board 1100 may be connected to the main board of the electronic device. There is a problem in that the thickness of the first circuit board 1100 increases or the layer structure of the first circuit board 1100 becomes complicated in order for the electrodes provided on the first circuit board 1100 to have a width and an interval to be respectively connected to the semiconductor device 1300 and the main board. Accordingly, in the first embodiment, the second circuit board 1200 may be disposed on the first circuit board 1100 and the semiconductor device 1300. In addition, the second circuit board 1200 may include electrodes having a fine width and an interval corresponding to the terminals of the semiconductor device 1300.

The semiconductor device 1300 may be an application processor (AP) chip including at least one of a central processor (CPU), a graphics processor (GPU), a digital signal processor, a cryptographic processor, a microprocessor and a microcontroller, or an analog-digital converter, an application-specific IC (ASIC), or the like, or a chip set comprising a specific combination of those listed so far. The memory chip may be a stack memory such as HBM. The memory chip may also include a memory chip such as volatile memory (e.g., DRAM), non-volatile memory (e.g., ROM), flash memory, and the like.

Meanwhile, the semiconductor package of the first embodiment may include a connection part.

For example, the semiconductor package may include a first connection part 1410 disposed between the first circuit board 1100 and the second circuit board 1200. The first connection part 1410 may electrically connect the second circuit board 1200 to the first circuit board 1100 while coupling them.

For example, the semiconductor package may include the second connection part 1420 disposed between the second circuit board 1200 and the semiconductor device 1300. The second connection part 1420 may electrically connect the semiconductor device 1300 to the second circuit board 1200 while coupling them.

The semiconductor package may include a third connection part 1430 disposed on a lower surface of the first circuit board 1100. The third connection part 1430 may electrically connect the first circuit board 1100 to the main board while coupling them.

At this time, the first connection part 1410, the second connection part 1420, and the third connection part 1430 may electrically connect between the plurality of components by using at least one bonding method of wire bonding, solder bonding and metal-to-metal direct bonding. That is, since the first connection part 1410, the second connection part 1420, and the third connection part 1430 have a function of electrically connecting a plurality of components, when the metal-to-metal direct bonding is used, the connection part of the semiconductor package may be understood as an electrically connected portion, not a solder or wire.

The wire bonding method may refer to electrically connecting a plurality of components using a conductive wire such as gold (Au). Also, the solder bonding method may electrically connect a plurality of components using a material containing at least one of Sn, Ag, and Cu. In addition, the metal-to-metal direct bonding method may refer to recrystallization by applying heat and pressure between a plurality of components without the presence of solder, wire, conductive adhesive, etc. In addition, to directly bond between the plurality of components. In addition, the metal-to-metal direct bonding method may refer to a bonding method by the second connection part 1420. In this case, the second connection part 1420 may mean a metal layer formed between a plurality of components by the recrystallization.

Specifically, the first connection part 1410, the second connection part 1420, and the third connection part 1430 may couple a plurality of components to each other by a thermal compression (TC) bonding method. The thermal compression bonding may refer to a method of directly coupling a plurality of components by applying heat and pressure to the first connection part 1410, the second connection part 1420, and the third connection part 1430.

At this time, at least one of the first circuit board 1100 and the second circuit board 1200 may be provided with a protrusion that protrudes outwardly away from the insulating layer of the corresponding board, on which the first connection part 1410, the second connection part 1420, and the third connection part 1430 are disposed. The protrusion may protrude outwardly from the first circuit board 1100 or the second circuit board 1200.

The protrusion may be referred to as a bump. The protrusion may also be referred to as a post. The protrusion may also be referred to as a pillar. Preferably, the protrusion may refer to an electrode on which a second connection part 1420 for coupling with the semiconductor device 1300 is disposed among the electrodes of the second circuit board 1200. That is, as the pitch of the terminals of the semiconductor device 1300 becomes finer, a short circuit may occur between the plurality of second connection parts 1420 that are respectively connected to the plurality of terminals of the semiconductor device 1300 by a conductive adhesive such as a solder. Therefore, in the embodiment, thermal compression bonding may be performed to reduce a volume of the second connection part 1420. In addition, in order to secure diffusion prevention and alignment to prevent an intermetallic compound (IMC) formed between a conductive adhesive such as solder and a protrusion from diffusing into the interposer and/or the circuit board, a protrusion may be included in the electrode of the second circuit board 1200 on which the second connection part 1420 is disposed.

In addition, the semiconductor package may include a connection member 1210.

The connection member may be referred to as a bridge circuit board. For example, the connection member 1210 may include a redistribution layer. The connection member 1210 may perform a function of electrically connecting a plurality of semiconductor devices horizontally to each other. For example, since the area that a semiconductor device should generally have been too large, the connection member 1210 may include a redistribution layer. Since the semiconductor package and the semiconductor device have a large difference in a width or spacing of the circuit pattern, etc., a buffering role of the circuit pattern for electrical connection is required. The buffering role may mean having a size between a width or spacing of the circuit pattern of the semiconductor package and a width or spacing of the circuit pattern of the semiconductor device, and the redistribution layer may include a function of performing the buffering role.

In an embodiment, the connection member 1210 may be an organic material bridge. For example, the connection member 1210 may include an organic material. For example, the connection member 1210 may include an organic circuit board including an organic material instead of the silicon circuit board. The connection member 1210 may be embedded in the second circuit board 1200.

For this purpose, the second circuit board 1200 may include a cavity, and the connection member 1210 may be disposed in the cavity of the second circuit board 1200. The connection member 1210 may horizontally connect a plurality of semiconductor devices disposed on the second circuit board 1200.

Referring to FIG. 1b, the semiconductor package according to the second embodiment may include a second circuit board 1200 and a semiconductor device 1300. In this case, the semiconductor package of the second embodiment may have a structure in which the first circuit board 1100 is removed compared to the semiconductor package of the first embodiment.

That is, the second circuit board 1200 of the second embodiment may function as a package circuit board while performing an interposer function.

The first connection part 1410 disposed on the lower surface of the second circuit board 1200 may couple the second circuit board 1200 to the main board of the electronic device.

Referring to FIG. 1c, the semiconductor package according to the third embodiment may include a first circuit board 1100 and a semiconductor device 1300.

In this case, the semiconductor package of the third embodiment may have a structure in which the second circuit board 1200 is omitted compared to the semiconductor package of the first embodiment.

That is, the first circuit board 1100 of the third embodiment can function as a package circuit board while also performing the function of connecting the semiconductor device 1300 and a main board. To this end, the first circuit board 1100 may include a connection member 1110 for connecting the plurality of semiconductor devices. The connection member 1110 may be an organic material bridge connecting a plurality of semiconductor devices.

Referring to FIG. 1d, the semiconductor package of the fourth embodiment further may include a third semiconductor device 1330 compared to the semiconductor package of the third embodiment.

To this end, a fourth connection part 1440 may be disposed on the lower surface of the first circuit board 1100.

In addition, a third semiconductor device 1330 may be disposed on the fourth connection part1400. That is, the semiconductor package of the fourth embodiment may have a structure in which semiconductor devices are mounted on upper and lower sides, respectively.

In this case, the third semiconductor device 1330 may have a structure disposed on the lower surface of the second circuit board 1200 in the semiconductor package of FIG. 1b.

Referring to FIG. 1e, the semiconductor package according to the fifth embodiment may include a first circuit board 1100. A first semiconductor device 1310 and a second semiconductor device 1320 may be disposed on the first circuit board 1100. To this end, a first connection part 1410 may be disposed between the first circuit board 1100 and the first semiconductor device 1310 the second semiconductor device 1320.

In addition, a connection member 1110 can be embedded in the first circuit board 1110. The connection member 1110 can horizontally connect the first and second semiconductor devices 1310 and 1320.

In addition, the first circuit board 1100 may include a conductive coupling portion 1450. The conductive coupling portion 1450 may further protrude from the first circuit board 1100 toward the second semiconductor device 1320. The conductive coupling portion 1450 may be referred to as a bump or, alternatively, may also be referred to as a post. The conductive coupling portion 1450 may be disposed to have a protruding structure on an electrode disposed on an uppermost side of the first circuit board 1100.

A third semiconductor device 1330 may be disposed on the conductive coupling portion 1450. In this case, the third semiconductor device 1330 may be connected to the first circuit board 1100 through the conductive coupling portion 1450. In addition, a second connection part 1420 may be disposed between the first semiconductor device 1310 and the second semiconductor device 1320 and the third semiconductor device 1330.

Accordingly, the third semiconductor device 1330 may be electrically connected to the first semiconductor device 1310 through the second connection part 1420.

That is, the third semiconductor device 1330 may be connected to the first circuit board 1100 through the conductive coupling portion 1450, and may be also connected to the first and second semiconductor devices 1310 and 1320 through the second connection part 1420.

In this case, the third semiconductor device 1330 may receive a power signal and/or electric power through the conductive coupling portion 1450. In addition, the third semiconductor device 1330 can exchange communication signals with the first and second semiconductor devices 1310 and 1320 through the second connection part 1420.

The semiconductor package according to the fifth embodiment may provide a power signal and/or electric power to the third semiconductor device 1330 through the conductive coupling portion 1450, thereby providing sufficient power for driving the third semiconductor device 1330 or enabling smooth control of a power operation.

Accordingly, the embodiment may improve the driving characteristics of the third semiconductor device 1330. That is, the embodiment may solve a problem of insufficient power provided to the third semiconductor device 1330. Furthermore, in the embodiment, at least one of a power signal, an electric power, and a communication signal of the third semiconductor device 1330 may be provided through different paths through the conductive coupling portion 1450 and the second connection part 1420. Through this, the embodiment can solve the problem that the communication signal is lost due to the power signal. For example, the embodiment may minimize mutual interference between communication signals of power signals.

Meanwhile, the second semiconductor device 1320 in the fifth embodiment may have a POP (Package On Package) structure in which a plurality of package circuit boards are stacked and may be disposed on the first circuit board 1100. For example, the third semiconductor device 1330 may be a memory package including a memory chip. In addition, the memory package may be coupled on the conductive coupling portion 1450. In this case, the memory package may not be connected to the first and second semiconductor devices 1310 and 1320.

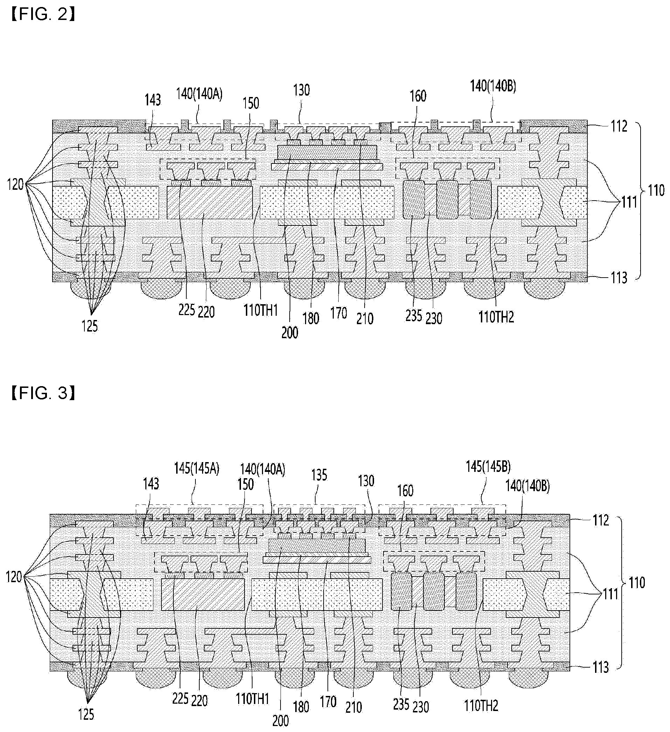

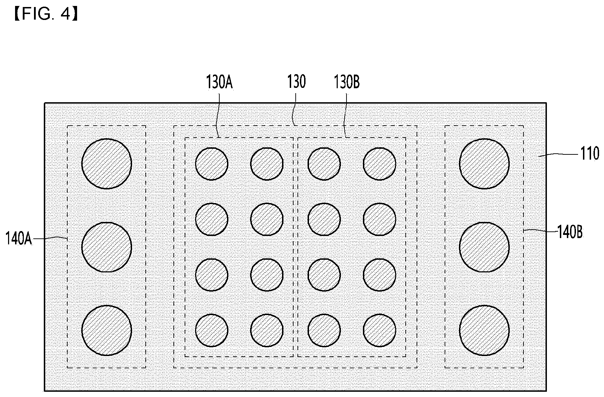

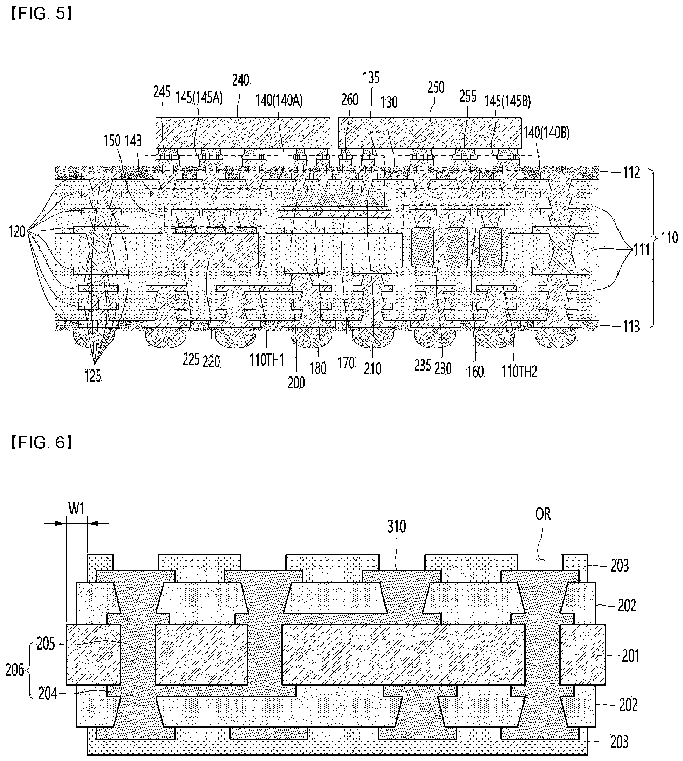

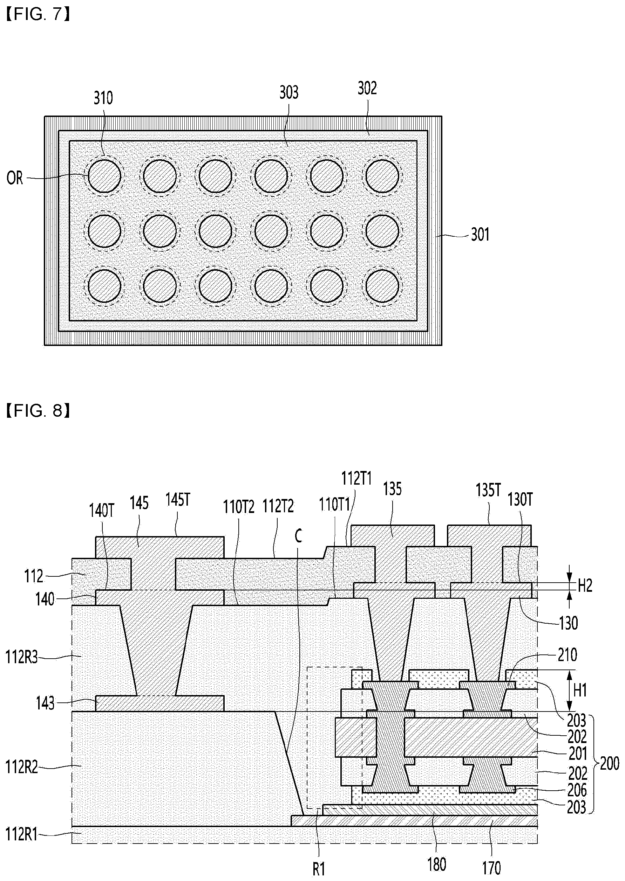

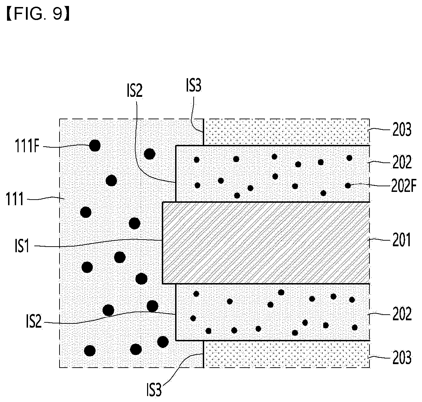

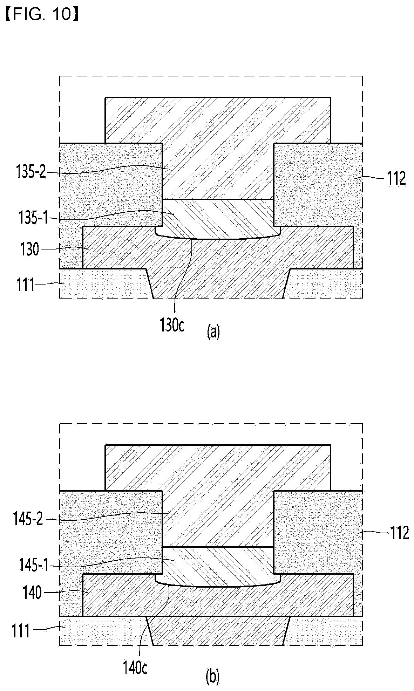

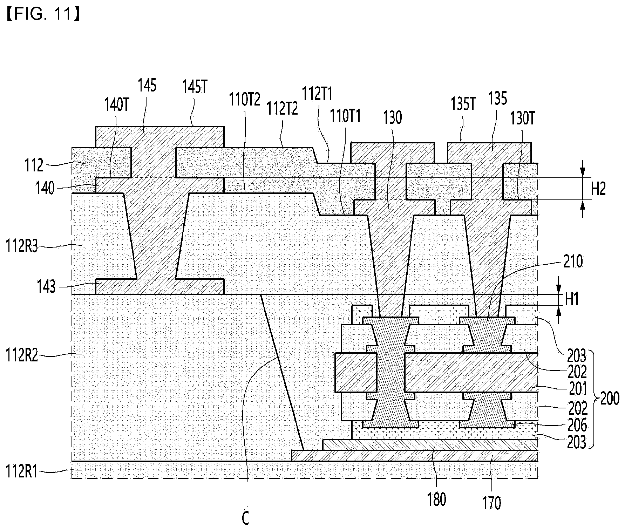

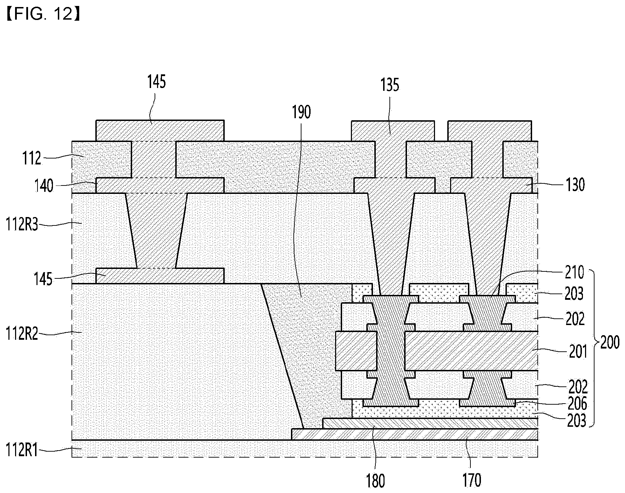

FIG. 2 is a cross-sectional view showing a circuit board according to a first embodiment, FIG. 3 is a cross-sectional view showing a circuit board according to a second embodiment, FIG. 4 is a plan view of a circuit board of FIG. 2 viewed from an upward direction, FIG. 5 is a cross-sectional view showing a state in which a plurality of semiconductor devices are coupled to a circuit board of FIG. 3, FIG. 6 is a cross-sectional view showing a detailed layer structure of the connection member of FIG. 2, FIG. 7 is a plan view of the connection member of FIG. 6 viewed from an upward direction, FIG. 8 is an enlarged cross-sectional view of a partial region of the circuit board of FIG. 3 according to a first embodiment, FIG. 9 is a drawing for explaining an interface between a build-up insulating layer and a connection member of FIG. 8, FIG. 10 is a cross-sectional view showing a detailed layer structure of a protruding electrode of an embodiment, FIG. 11 is an enlarged cross-sectional view of a partial region of a circuit board of FIG. 3 according to a second embodiment, and FIG. 12 is an enlarged cross-sectional view of a partial region of the circuit board of FIG. 3 according to a third embodiment.

Hereinafter, a semiconductor package according to an embodiment will be specifically described with reference to FIGS. 2 to 12.

Before describing the embodiment, FIGS. 2 and 3 can be distinguished depending on whether a protruding electrode is provided at an uppermost side of the circuit board. For example, the circuit board of FIG. 3 may be provided with a protruding electrode 145. For example, the circuit board of FIG. 2 may not be provided with a protruding electrode. In addition, the second insulating layer 112 of the circuit board of FIG. 2 may include an opening larger than widths of a first electrode part 130 and a second electrode part 140 through thinning of the second insulating layer 112. In addition, the circuit board of FIG. 2 may proceed with bonding with the semiconductor device at the opening, and thereby may be stably bonded with the semiconductor device even without the protruding electrode.

Referring to FIGS. 2 and 3, a circuit board according to the first embodiment may include a build-up insulating layer 110, an electrode part, and a connection member 200. The build-up insulating layer 110 may include a plurality of insulating layers built up along a vertical direction. The build-up insulating layer 110 may include a first insulating layer 111, a second insulating layer 112, and a third insulating layer 113. The first insulating layer 111 may constitute an inner layer of the build-up insulating layer. The second insulating layer 112 may be disposed on the first insulating layer 111. For example, the second insulating layer 112 may mean an insulating layer disposed at an uppermost side of the build-up insulating layer. The third insulating layer 113 may be disposed below the first insulating layer 111. For example, the third insulating layer 113 may mean an insulating layer disposed at a lowermost side of the build-up insulating layer.

The first insulating layer 111 of the circuit board may have a layer structure of at least one layer. Preferably, the first insulating layer 111 of the circuit board may have a plurality of laminated structures. The laminated structures may be distinguished by the electrode part. For example, the electrode part may include a connection electrode 120 and a through electrode 125. The connection electrode 120 and the through electrode 125 may have different widths. In addition, the laminated structure may be distinguished by a difference in the widths of the connection electrode 120 and the through electrode 125. The connection electrode 120 may have a larger width than the through electrode 125. Through this, the connection electrode 120 and the through electrode 125 may be distinguished in an electrode part. The connection electrode 120 may mean a pad and/or trace of an electrode part. The through electrode 125 may mean a via electrode connected to the connection electrode. The through electrode 125 may be disposed between a plurality of connection electrodes 120 disposed on different layers. Through the above-described laminated structure, the circuit board of the embodiment may electrically and efficiently connect at least one semiconductor device and/or a second circuit board to the main board.

At this time, the first insulating layer 111 of the circuit board of FIG. 2 is illustrated as having a 7-layer structure, but is not limited thereto. For example, the first insulating layer 111 of the circuit board may have a number of layers of 6 or less, or may have a number of layers of 8 or more. In addition, when the plurality of first insulating layers 111 of the circuit board include a same insulating material, an interface between the plurality of insulating layers may not be distinguished. In this case, the laminated structure can be distinguished by the connection electrode 120 and the through electrode 125 of the electrode part.

Meanwhile, when the first insulating layer 111 of the circuit board has a multi-layer structure, a plurality of first insulating layers may include a same insulating material, but are not limited thereto. For example, at least one of the plurality of first insulating layers may include an insulating material different from at least one other first insulating layer.

The first insulating layer 111 of the circuit board may be rigid or flexible. For example, the first insulating layer 111 of the circuit board may include glass or plastic. For example, the first insulating layer 111 of the circuit board may include chemically strengthened/semi-strengthened glass such as soda lime glass or aluminosilicate glass. For example, the first insulating layer 111 of the circuit board may include a reinforced or flexible plastic such as polyimide (PI), polyethylene terephthalate (PET), propylene glycol (PPG), or polycarbonate (PC). For example, the first insulating layer 111 of the circuit board may include sapphire. For example, the first insulating layer 111 of the circuit board may include an optically isotropic film. For example, the first insulating layer 111 of the circuit board may include COC (Cyclic Olefin Copolymer), COP (Cyclic Olefin Polymer), optically isotropic polycarbonate (PC), or optically isotropic polymethylmethacrylate (PMMA). For example, the first insulating layer 111 of the circuit board may be formed of a material including an inorganic filler and an insulating resin. For example, the first insulating layer 111 of the circuit board may have a structure in which an inorganic filler such as silica or alumina is disposed in a thermosetting resin or a thermoplastic resin.

The first insulating layer 111 may have a structure in which a plurality of different insulating materials are laminated, and an exemplary arrangement structure will be described in more detail as follows.

In one embodiment, the first insulating layer 111 may include a first layer corresponding to a core layer including a reinforcing member. Here, the core layer may mean an insulating layer including a reinforcing member and having a thickness in a vertical direction exceeding 30 µm. In addition, the insulating layer may include a plurality of second layers respectively disposed on upper and lower portions of the core layer and not including a reinforcing member. In this case, the circuit board may be a core circuit board. The reinforcing member may also be referred to as a reinforcing fiber or a glass fiber.

The reinforcing member may mean a glass fiber material extending along a horizontal direction of the insulating layer, and may have a different meaning from an inorganic filler spaced apart from each other. That is, the reinforcing member of the first layer may have different lengths or widths along the horizontal direction from the filler of the second layer. In addition, the reinforcing member of the first layer may have a structure that is elongated along one direction, but since the filler of the second layer has an arbitrary size and is dispersed and disposed, the reinforcing member of the first layer and the filler of the second layer can be distinguished from each other. For example, the glass fiber may be extended to have a width greater than the width of the first layer. Here, the meaning of having a width greater than the width of the first layer may mean that the glass fiber can be disposed in a shape that is bent in the horizontal direction. In addition, even if the second layer includes the filler, an effect of preventing problems such as bending is not greater than that of the glass fiber of the first layer, so the reinforcing member is described separately from the filler of the second layer.

In another embodiment, the first insulating layer 111 of the circuit board may be a coreless circuit board that does not include a core layer. For example, the first insulating layer 111 of the circuit board may include an organic material that does not include a reinforcing member, which enables excellent processability, slimming of the circuit board, and miniaturization of the electrode part of the circuit board. For example, the first insulating layer 111 of the circuit board may use ABF (Ajinomoto Build-up Film), a product released by Ajinomoto Co., Ltd., and FR-4, BT (Bismaleimide Triazine), PID (Photo Imageable Dielectric resin), BT, etc. may be used. For example, the first insulating layer 111 may include a plurality of layers composed of ABF.

At this time, if the first insulating layer 111 of the circuit board is composed only of ABF that does not include a reinforcing member, warpage characteristics of the circuit board may be deteriorated. Accordingly, the first insulating layer 111 of the circuit board is composed of ABF (Ajinomoto Build-up Film), and at least one ABF among the plurality of ABFs constituting the first insulating layer of the circuit board may include a reinforcing member.

For example, the first insulating layer 111 of the circuit board may include a first layer composed of a first ABF including a resin and a filler. In addition, the first insulating layer 111 of the circuit board may include a layer composed of a second ABF including a resin, a filler, and a reinforcing member. At this time, the reinforcing member included in the second ABF may include a GCP (Glass Core Primer) material, but is not limited thereto.

A layer of the first insulating layer 111 of the circuit board that does not include the reinforcing member may have a thickness in a range of 10 µm to 40 µm. Preferably, a layer of the first insulating layer 111 of the circuit board that does not include the reinforcing member can satisfy a thickness in a range of 15 µm to 35 µm. More preferably, the layer of the first insulating layer 111 of the circuit board that does not include the reinforcing member can satisfy a thickness in a range of 18 µm to 32 µm. If the thickness of the layer of the first insulating layer 111 of the circuit board that does not include the reinforcing member is less than 10 µm, the rigidity of the circuit board may be deteriorated. In addition, if the thickness of the layer of the first insulating layer 111 of the circuit board that does not include the reinforcing member is less than 10 µm, the electrode part of the circuit board may not be stably protected, and thus the electrical reliability may be deteriorated. In addition, if the thickness of the layer of the first insulating layer 111 of the circuit board that does not include the reinforcing member exceeds 40 µm, an overall thickness of the circuit board may increase, and thus a thickness of the semiconductor package may increase. In addition, if the thickness of the layer of the first insulating layer 111 of the circuit board that does not include the reinforcing member exceeds 40 µm, it may be difficult to miniaturize the electrode part of the circuit board.

The thickness may correspond to a distance in a vertical direction of the circuit board between the connection electrodes 120 disposed in different layers. That is, the thickness may mean a length in a direction from an upper surface to a lower surface of the circuit board, or from the lower surface to the upper surface, and may mean a length in a vertical direction of the circuit board. Here, the upper surface may mean a highest position along the vertical direction in each component, and the lower surface may mean a lowest position along the vertical direction in each component. In addition, the positions thereof may be referred to oppositely.

An upper surface of the first insulating layer 111 may have a step. For example, the first insulating layer 111 may include a convex portion. Alternatively, the first insulating layer 111 may include a concave portion. For example, an upper surface of the first insulating layer 111 that vertically overlaps the connection member 200 and an upper surface that does not vertically overlap the connection member 200 may have different heights. This will be described in more detail below.

In addition, the insulating layer of the circuit board may include a second insulating layer 112 and a third insulating layer 113. The second insulating layer 112 and the third insulating layer 113 of the circuit board may be resist layers. For example, the second insulating layer 112 of the circuit board may be a first resist layer disposed at an uppermost side of the circuit board. In addition, the third insulating layer 113 of the circuit board may be a second resist layer disposed at a lowermost side of the circuit board. The resist layer may have a function of preventing a flow of solder during solder bonding by having a low wettability characteristic of solder, or may have a function of preventing moisture or contaminants from an outside from penetrating into an inside of the circuit board.

At this time, the second insulating layer 112 of the circuit board may include a same insulating material as the first insulating layer 111 of the circuit board. For example, when the first insulating layer 111 of the circuit board is composed of a plurality of layers, the first insulating layer most adjacent to the second insulating layer 112 among the plurality of first insulating layers may include a same insulating material as the second insulating layer 112. In this case, it may be difficult to distinguish an interface between the first insulating layer 111 and the second insulating layer 112 of the circuit board. In this case, the connection electrode 120 and the through electrode 125 of the electrode part disposed on the first insulating layer 111 and the second insulating layer 112 of the circuit board can be used to distinguish the interface between the first insulating layer 111 of the circuit board and the second insulating layer 112.

Correspondingly, the third insulating layer 113 of the circuit board can include a same insulating material as the first insulating layer 111 of the circuit board.

The second insulating layer 112 and the third insulating layer 113 of the circuit board can have a function of protecting the upper and lower surfaces of the first insulating layer 111 of the circuit board, respectively. Accordingly, the second insulating layer 112 and the third insulating layer 113 of the circuit board can be referred to as protective layers. For example, the second insulating layer 112 may be an upper protective layer disposed on the first insulating layer 111 built up along the vertical direction, and the third insulating layer 113 may be a lower protective layer.

The second insulating layer 112 and the third insulating layer 113 of the circuit board may be solder resist layers including an organic polymer material. For example, the second insulating layer 112 and the third insulating layer 113 of the circuit board may include an epoxy acrylate series resin. In detail, the second insulating layer 112 and the third insulating layer 113 of the circuit board may include a resin, a curing agent, a photoinitiator, a pigment, a solvent, a filler, an additive, an acrylic series monomer, etc. However, the embodiment is not limited thereto, and the second insulating layer 112 and the third insulating layer 113 of the circuit board may be any one of a photo solder resist layer, a cover-lay, and a polymer material.

A thickness of each of the second insulating layer 112 and the third insulating layer 113 of the circuit board may be 1 µm to 20 µm. The thickness of each of the second insulating layer 112 and the third insulating layer 113 of the circuit board may be 1 µm to 15 µm. For example, the thickness of each of the second insulating layer 112 and the third insulating layer 113 of the circuit board may be 5 µm to 20 µm.

If the thickness of each of the second insulating layer 112 and the third insulating layer 113 of the circuit board exceeds 20µm, the thickness of the semiconductor package may increase, and thus it may be difficult to thin-film, or the stress applied to the first insulating layer 111 may increase. If the thickness of each of the second insulating layer 112 and the third insulating layer 113 of the circuit board is less than 1 µm, it may be difficult to stably protect the electrode part included in the circuit board, and thus the electrical reliability or physical reliability may deteriorate.

Meanwhile, an upper surface of the second insulating layer 112 may have a step. For example, the second insulating layer 112 may include a convex portion. Alternatively, the second insulating layer 112 may include a concave portion. For example, an upper surface of the second insulating layer 112 that vertically overlaps the connection member 200 and an upper surface that does not vertically overlap the connection member 200 may have different heights. This will be described in more detail below.

The circuit board may include an electrode part. The electrode part of the circuit board may be disposed in the first insulating layer 111. For example, at least a part of the electrode part may be embedded in the first insulating layer 111. For example, at least a part of the electrode part may be embedded in the second insulating layer 112. For example, at least a part of the electrode part may be embedded in the third insulating layer 113. In addition, at least a part of the electrode part may protrude above the second insulating layer 112. In addition, at least a part of the electrode part may protrude below the third insulating layer 113.

The electrode part may mainly include a connection electrode 120 and a through electrode 125. The connection electrode 120 may be disposed adjacent to the upper or lower surface of each layer of the first insulating layer 111. The through electrode 125 may be connected to the connection electrode 120. The through electrode 125 may penetrate at least a part of each layer of the first insulating layer 111. At this time, the connection electrode 120 may be referred to as a pad or a trace depending on a position and function. In addition, the through electrode 125 may also be referred to as a via electrode

At this time, when the first insulating layer 111 of the circuit board has a 7-layer structure, the through electrode 125 of the electrode part may have a 4-layer structure in which each connection electrode 120 is interposed between them while being spaced apart from each other along the vertical direction.

Meanwhile, at least one of the connection electrodes 120 of the circuit board may have an ETS (Embedded Trace Substrate) structure. For example, an electrode disposed at the uppermost or lowermost side of the connection electrode 120 may be disposed in a recess provided in the first insulating layer 111. The ETS structure may also be referred to as an embodied structure. The ETS structure is advantageous for miniaturization compared to an electrode part having a general protruding structure. Accordingly, the embodiment enables a formation of the electrodes to correspond to a size and pitch of terminals provided in the semiconductor device. Through this, the embodiment can improve the circuit integration. In addition, the embodiment can minimize a transmission distance of a signal transmitted through the semiconductor device, thereby minimizing signal transmission loss.

The connection electrode 120 can have a function of transmitting a signal in a horizontal direction in the first insulating layer 111. In addition, the connection electrode 120 can have a function of connecting between a plurality of through electrodes 125. The through electrode 125 can have a function of transmitting a signal in a vertical direction in the first insulating layer 111. For example, the through electrode 125 can connect between connection electrodes 120 disposed in different layers along a vertical direction.

The electrode part can include a plurality of electrode parts depending on the location. For example, the electrode part can include a plurality of electrode parts connected to the semiconductor device and/or the connection member 200.

The electrode part can include a first electrode part 130 and a second electrode part 140. The first electrode part 130 and the second electrode part 140 can be distinguished based on a position of the connection member 200 embedded in the first insulating layer 111. The first electrode part 130 and the second electrode part 140 can penetrate from an upper surface of the first insulating layer 111 to a partial region of the first insulating layer 111.

The first electrode part 130 can vertically overlap the connection member 200 and penetrate from the upper surface of the first insulating layer 111 to a portion of the first insulating layer. For example, the first electrode part 130 can be an electrode connecting a semiconductor device and the connection member 200. A portion of the first electrode part 130 can be connected to the first semiconductor device, and the remaining portion can be connected to the second semiconductor device. In addition, the first electrode part 130 can be connected to the connection member 200 to electrically connect the first and second semiconductor devices.

The second electrode part 140 may penetrate from the upper surface of the first insulating layer 111 to a portion of the first insulating layer without vertically overlapping the connection member 200. The second electrode part 140 may be an electrode part that horizontally overlaps the first electrode part 130. The second electrode part 140 may be an electrode connected to the semiconductor device. For example, the second electrode part 140 may be an electrode part connected to a same semiconductor device as the semiconductor device to which the first electrode part 130 is connected. However, unlike the first electrode part 130, the second electrode part 140 may not be directly electrically connected to the connection member 200. The second electrode part may electrically connect between the circuit board and the first semiconductor device and/or the second semiconductor device.

The first electrode part 130 and the second electrode part 140 may be disposed above the connection member 200 in the first insulating layer 111. The first electrode part 130 may mean an electrode part overlapping the connection member 200 in a vertical direction. In addition, the second electrode part 140 may mean an electrode part that overlaps the first electrode part 130 in a horizontal direction, but does not overlap the connection member 200 in a vertical direction.

In addition, each of the first electrode part 130 and the second electrode part 140 may mean an electrode that is connected to a semiconductor device. For example, the first and second semiconductor devices may be disposed on the circuit board of the embodiment to be spaced apart from each other in a horizontal direction. In addition, the first electrode part 130 may mean an electrode part that overlaps the connection member 200 in a vertical direction and is connected to the first and second semiconductor devices. In addition, the second electrode part 140 may mean an electrode part that is connected to at least one of the first and second semiconductor devices without being vertically overlapped with the connection member 200.

Specifically, the first electrode part 130 may penetrate from an upper surface of the first insulating layer 111 to a portion of the first insulating layer 111 in a region vertically overlapped with the connection member 200. In one embodiment, the first electrode part 130 may be an electrode that directly connects the semiconductor device and the connection member. In another embodiment, the first electrode part 130 may be an electrode that connects between a first protruding electrode 135 connected to the semiconductor device and the connection member 200.

The second electrode part 140 may penetrate from the upper surface of the first insulating layer 111 to a portion of the first insulating layer 111 in a region that does not vertically overlap with the connection member 200. In one embodiment, the second electrode part 140 may be an electrode that is directly connected to the same semiconductor device as the first electrode part 130. In another embodiment, the second electrode part 140 may be an electrode that is connected to a second protruding electrode 145 connected to the semiconductor device.

The first protruding electrode 135 and the second protruding electrode 145 may be bumps. The first protruding electrode 135 and the second protruding electrode 145 may be provided for easy coupling between the circuit board and the semiconductor device. The first protruding electrode 135 and the second protruding electrode 145 may refer to electrodes on which a conductive adhesive is disposed for bonding with a semiconductor device.

The first electrode part 130 may be connected to the connection member 200. For example, the first electrode part 130 may be connected to a pad 310 provided on the connection member 200.

In addition, the second electrode part 140 may be connected to the connection electrode 143 that is horizontally overlapped with the connection member 200 or the first electrode part 130. At this time, heights of an upper surface of the connection electrode 143 and an upper surface of the pad 310 of the connection electrode 143 may be different from each other.

Accordingly, a lower surface of the first electrode part 130 and a lower surface of the second electrode part 140 may have different heights.

In one embodiment, a lower surface of the first electrode part 130 may be positioned lower than a lower surface of the second electrode part 140. At this time, an upper surface of the first electrode part 130 may be positioned lower than an upper surface of the second electrode part 140.

In another embodiment, a lower surface of the first electrode part 130 may be positioned lower than a lower surface of the second electrode part 140. At this time, an upper surface of the first electrode part 130 may be positioned higher than an upper surface of the second electrode part 140.

The electrode part may include a third electrode part 150. The third electrode part 150 may be embedded in the first insulating layer 111. For example, the third electrode part 150 may penetrate a portion of a region inside the first insulating layer 111. The third electrode part 150 may be connected to the third semiconductor device 220 embedded in the first insulating layer 111. For example, the third electrode part 150 may be vertically overlapped with the third semiconductor device 220. A lower surface of the third electrode part 150 may be connected to a terminal 225 of the third semiconductor device 220. The third electrode part 150 may have a function of electrically connecting between the circuit board and a terminal 225 of the embedded third semiconductor device 220.

The electrode part may include the fourth electrode part 160. The fourth electrode part 160 may be embedded in the first insulating layer 111. For example, the fourth electrode part 160 may penetrate a portion of a region inside the first insulating layer 111. The fourth electrode part 160 may be connected to the fourth semiconductor device 230 embedded in the first insulating layer 111. For example, the fourth electrode part 160 may be vertically overlapped with the fourth semiconductor device 230. A lower surface of the fourth electrode part 160 may be connected to a terminal 235 of the fourth semiconductor device 230. The fourth electrode part 160 may function to electrically connect between the circuit board and a terminal 235 of the embedded fourth semiconductor device 230.

The electrode part may include a fifth electrode part 170. The fifth electrode part 170 may be vertically overlapped with the connection member 200. The fifth electrode part 170 may be embedded in the first insulating layer 111. The fifth electrode part 170 may be an electrode used to form an accommodation space for accommodating the connection member 200 in the first insulating layer 111. For example, the fifth electrode part 170 may be an etch-stop electrode. For example, the fifth electrode part 170 may be a laser-stop electrode.

The electrode part may include a protruding electrode. The electrode part may include a first protruding electrode 135. The first protruding electrode 135 may be provided on the first electrode part 130. The first protruding electrode 135 may protrude onto the second insulating layer 112. The first protruding electrode 135 may improve bonding between the semiconductor device and the circuit board. A fact that the first protruding electrode 135 protrudes above the second insulating layer 112 may mean that an upper surface of the first protruding electrode 135 is positioned higher than upper surfaces of other components of the circuit board. For example, it may mean that an upper surface of the first protruding electrode 135 is positioned at the uppermost side of the circuit board.

In addition, the electrode part may include a second protruding electrode 145. The second protruding electrode 145 may be provided on the second electrode part 140. The second protruding electrode 145 may protrude above the second insulating layer 112. The second protruding electrode 145 may improve the bonding between the semiconductor device and the circuit board. A fact that the second protruding electrode 145 protrudes above the second insulating layer 112 may mean that the upper surface of the second protruding electrode 145 is positioned higher than the upper surfaces of other components of the circuit board. For example, it may mean that the upper surface of the second protruding electrode 145 is positioned at the uppermost side of the circuit board together with the first protruding electrode 135.

The first protruding electrode 135 and the second protruding electrode 145 may be referred to as bumps. The first protruding electrode 135 and the second protruding electrode 145 may also be referred to as posts. The first protruding electrode 135 and the second protruding electrode 145 may also be referred to as pillars. Preferably, the first protruding electrode 135 and the second protruding electrode 145 may refer to electrodes on which a conductive bonding member for coupling with the semiconductor device is disposed. That is, as a pitch of the terminals of the semiconductor device becomes finer, a short circuit may occur between a plurality of conductive connection members each connected to a plurality of terminals of the semiconductor device by a conductive adhesive such as solder. Therefore, in the embodiment, thermal compression bonding may be performed to reduce a volume of the conductive bonding member. Accordingly, the embodiment is provided with the first protruding electrode 135 and the second protruding electrode 145 to secure the diffusion preventing power to prevent the intermetallic compound (IMC) formed between the conductive adhesive such as solder and the protrusion from diffusing into the circuit board, such as the alignment, diffusion, and the like.

A connection member 200 may be embedded in the first insulating layer 111. In the embodiment, the connection member 200 may be an organic bridge. For example, the organic bridge may be a bridge including an organic insulating layer. The organic bridge may be embedded in the first insulating layer 111 and may function to connect between different semiconductor devices through this. To this end, the organic bridge may be provided with a higher density or finer electrode than the electrode part of the circuit board, and may horizontally connect between a plurality of semiconductor devices mounted on the circuit board through this.

The connection member 200 may be embedded in the first insulating layer 111. At this time, at least a part of insulating layers constituting the connection member 200 may include an insulating material different from that of the first insulating layer 111. Through this, at least a part of a side surface of the connection member 200 embedded in the first insulating layer 111 may be distinguished from the first insulating layer 111. The side surface of the connection member 200 may have a step. For example, the connection member 200 may be composed of a plurality of layers. In addition, the plurality of layers of the connection member 200 may have different widths. Accordingly, the connection member 200 may have a structure in which a plurality of layers having different widths are laminated, and thereby the side surface may have a step.

The connection member 200 may include a plurality of insulating layers including different insulating materials. In addition, the side surface of the plurality of insulating layers may have a step. In addition, the side surface of the connection member 200 having the step can be in contact with the first insulating layer 111. Through this, a contact area between the first insulating layer 111 and the connection member 200 can be improved. Through this, a problem of the connection member 200 being peeled off from the first insulating layer 111 can be solved.

Meanwhile, the connection member 200 can include an insulating member 180. The insulating member 180 can be an adhesive member. For example, the insulating member 180 can be disposed between the fifth electrode part 170 and the connection member 200. The insulating member 180 can have a different width from the connection member 200. For example, a width of the insulating member 180 can be larger than a width of a region having a largest width among outer widths of the connection member 200. The insulating member 180 may be disposed on the fifth electrode part 170. The width of the insulating member 180 may be smaller than the width of the fifth electrode part 170. Therefore, at least a portion of the upper surface of the fifth electrode part 170 may be in contact with the insulating member 180, and the remaining portion may be in contact with the first insulating layer 111.

Meanwhile, a plurality of semiconductor devices may be coupled to the circuit board.

For example, a plurality of semiconductor devices may be coupled to the circuit board. For example, a plurality of semiconductor devices may be embedded in the circuit board.

Specifically, a plurality of semiconductor devices may be coupled to the outside of the circuit board and spaced apart from each other in the horizontal direction. In addition, a plurality of semiconductor devices may be embedded in the first insulating layer 111 of the circuit board and spaced apart from each other in the horizontal direction.

For example, the first insulating layer 111 may include a first receiving portion 110TH1 in which a third semiconductor device 220 is embedded. In addition, the third semiconductor device 220 may be embedded in the first receiving portion 110TH1. In addition, the third semiconductor device 220 may be connected to the third electrode part 150. The third semiconductor device 220 may be an integrated passive device (IPD), but is not limited thereto.

In addition, the first insulating layer 111 may include a second receiving portion 110TH2 in which a fourth semiconductor device 230 is embedded. In addition, the fourth semiconductor device 230 may be embedded in the second receiving portion 110TH2 of the first insulating layer 111. The fourth semiconductor device 230 may be connected to the fourth electrode part 160. The fourth semiconductor device 230 may be a multilayer ceramic condenser (MLCC, Multi-Layer Ceramic Condenser, Multi-Layer Ceramic Capacitor) or a Si-based condenser, but is not limited thereto.

Hereinafter, detailed structures of the connection member 200, the first electrode part 130, the second electrode part 140, the pad 210 of the connection member 200, and the connection electrode 143 according to the embodiment will be specifically described.

Referring to FIGS. 4 and 5, the first electrode part 130 and the second electrode part 140 may be divided into a plurality of groups.

For example, each of the first electrode part 130 and the second electrode part 140 may be an electrode part connected to a semiconductor device. For example, the semiconductor device may include first and second semiconductor devices 240 and 250. In addition, each of the first electrode part 130 and the second electrode part 140 may mean an electrode connected to the first and second semiconductor devices.

In addition, the first electrode part 130 and the second electrode part 140 may be distinguished from each other depending on their positions. For example, the first electrode part 130 may be an electrode part that is vertically overlapped with the connection member 200. In addition, the second electrode part 140 may be an electrode part that is horizontally overlapped with the first electrode part 130 but does not vertically overlap with the connection member 200.

Each of the first electrode part 130 and the second electrode part 140 may be distinguished into a plurality of groups.

The first electrode part 130 may include a first electrode part 130A of a first group and a first electrode part 130B of a second group. The first electrode part 130A of the first group may mean an electrode part that vertically overlaps with the first semiconductor device 240. For example, the first electrode part 130A of the first group may mean an electrode part that is connected to the first semiconductor device 240. The first electrode part 130B of the second group may mean an electrode part that vertically overlaps with the second semiconductor device 250. For example, the first electrode part 120B of the second group may mean an electrode part that is connected to the second semiconductor device 250.

The second electrode part 140 may include a second electrode part 140A of a first group and a second electrode part 140B of a second group. The second electrode part 140A of the first group may be disposed adjacent to the first electrode part 130A of the first group. For example, the second electrode part 140A of the first group may be disposed at one side of the first electrode part 130A of the first group. The second electrode part 140A of the first group may be vertically overlapped with the first semiconductor device. The second electrode part 140A of the first group may be connected to the first semiconductor device. The second electrode part 140B of the second group may be disposed adjacent to the first electrode part 130B of the second group. For example, the second electrode part 140B of the second group may be disposed at another side of the first electrode part 140B of the second group. The second electrode part 140B of the second group may be vertically overlapped with the second semiconductor device. The second electrode part 140B of the second group may be connected to the first semiconductor device.

Correspondingly, the first protruding electrode 135 may include the first protruding electrode of a first group disposed on the first electrode part 130A of the first group, and the first protruding electrode of a second group disposed on the first electrode part 130B of the second group.

In addition, the second protruding electrode 145 may include the second protruding electrode of a first group disposed on the second electrode part 140A of the first group, and the second protruding electrode of a second group disposed on the second electrode part 140B of the second group.

In addition, a conductive adhesive member 260 may be disposed on the first protruding electrode of the first group, the first protruding electrode of the second group, the second protruding electrode of the first group, and the second protruding electrode of the second group.

Meanwhile, referring to FIG. 6 and FIG. 7, the connection member 200 may be an organic bridge. The connection member 200 may include an organic insulating layer. For example, the connection member 200 may include a plurality of organic insulating layers.

The connection member 200 may include a first insulating layer 201, a second insulating layer 202, and a third insulating layer 203.

In addition, the first insulating layer 201, the second insulating layer 202, and the third insulating layer 203 may include different insulating materials. However, the embodiment is not limited thereto. For example, the first insulating layer 201 may include an organic material. The first insulating layer 201 may include a different material from the second insulating layer 202, but is not limited thereto.

The first insulating layer 201 may have a characteristic that enables a formation of an electrode layer 206 of the connection member 200 including a micro electrode pattern. For example, the first insulating layer 201 may include an insulating material having excellent processability and elasticity. For example, the first insulating layer 201 of the connection member 200 may include polyimide (PI). In this case, the connection member of a prior art was an inorganic bridge, for example, a silicon bridge. The silicon has a coefficient of thermal expansion that is different from a coefficient of thermal expansion of the first insulating layer 111 of the circuit board, and thus may have a problem in that cracks easily occur due to thermal stress. In addition, the organic bridge may have an advantage in that a process unit cost or material cost, etc. may be lowered compared to the silicon bridge, thereby lowering an overall price of the product.

In contrast, the first insulating layer 201 of the connection member 200 of the embodiment may include an organic material having a similar coefficient of thermal expansion to that of the first insulating layer 111 of the circuit board. Through this, the embodiment may minimize stress applied to the connection member 200. Furthermore, the embodiment may solve a problem in which cracks occur in the connection member 200 or the connection member 200 is peeled off from the circuit board. Through this, the embodiment may improve mechanical reliability and electrical reliability of the semiconductor package.

In addition, the embodiment may reduce the cost of the connection member 200 by changing the first insulating layer 201 of the connection member 200 to polyimide, which is cheaper than silicon.

In addition, the connection member 200 may be provided with via electrodes having a small width. In addition, an alignment state between the plurality of via electrodes provided in different layers can have a great influence on operating characteristics of the connection member 200, operating characteristics of the semiconductor package, and operating characteristics of the electronic product or server to which the semiconductor package is applied. At this time, the polyimide can have a transparent characteristic. Accordingly, the embodiment can improve the alignment state of the plurality of via electrodes provided in different layers. Through this, the operating characteristics of the connection member 200, the operating characteristics of the semiconductor package, and the operating characteristics of the electronic product or server to which the semiconductor package is applied can be further improved.

In addition, the first insulating layer 201 can mean an insulating layer provided in an inner layer of the connection member 200. In addition, overall characteristics of the connection member 200 can be determined by characteristics of the first insulating layer 201. At this time, the first insulating layer 201 can have elasticity while having a similar coefficient of thermal expansion to that of the insulating layer of the circuit board. By this, the first insulating layer 201 of the connection member 200 can flow together with the circuit board when the circuit board is thermally deformed. Through this, the embodiment can solve a problem of cracks in the connection member 200 that may occur due to thermal deformation of the circuit board.

In addition, the embodiment can easily control a thickness of the connection member 200 by making the first insulating layer 201 of the connection member 200 include polyimide (PI). Through this, the embodiment can minimize a difference between a depth of a cavity C, which is an accommodation space of the connection member 200 formed in the circuit board, and a thickness of the connection member 200. Through this, the embodiment can minimize a height difference between the first electrode part 130 and the second electrode part 140 and/or a height difference between the first protruding electrode 135 and the second protruding electrode 145. Through this, the embodiment can stably couple a semiconductor device onto the first protruding electrode 135 and the second protruding electrode 145.

The connection member 200 may include a second insulating layer 202 disposed on the first insulating layer 201. The second insulating layer 202 may include an insulating material different from that of the first insulating layer 201, but is not limited thereto. For example, the second insulating layer 202 may include polyimide, which is the same insulating material as that of the first insulating layer 201. For example, the first insulating layer 201 may include an insulating material identical to that of the second insulating layer 202 described below instead of the polyimide.

The second insulating layer 202 may include a photosensitive material. For example, the second insulating layer 202 may include PID. For example, the second insulating layer 202 may be a PID in which a photosensitive material is a resin layer and a filler is dispersed within the resin layer.

In another embodiment, the second insulating layer 202 may include a same insulating material as the first insulating layer 111 of the circuit board. For example, the second insulating layer 202 may include ABF, which is a same insulating material as the first insulating layer 111 of the circuit board. Meanwhile, the second insulating layer 202 may be disposed on each of both surfaces of the first insulating layer 201.

In addition, the connection member 200 may include a third insulating layer 203 disposed on the second insulating layer 202. The third insulating layer 203 may be a protective layer. For example, the third insulating layer 203 may be a solder resist layer.

At this time, a side surface of the connection member 200 may have a step. For example, the first insulating layer 201, the second insulating layer 202, and the third insulating layer 203 of the connection member 200 may have steps.

For example, a width of the first insulating layer 201 of the connection member 200 in the horizontal direction may be different from a width of the second insulating layer 202 in the horizontal direction and a width of the third insulating layer 203 in the horizontal direction. Preferably, the width of the first insulating layer 201 of the connection member 200 in the horizontal direction may be larger than the width of the second insulating layer 202 in the horizontal direction and the width of the third insulating layer 203 in the horizontal direction.

That is, among the insulating layers of the connection member 200, the elasticity and/or rigidity of the first insulating layer 201 may be a highest compared to the second insulating layer 202 and the third insulating layer 203. Accordingly, the embodiment allows the first insulating layer 201 of the connection member 200 to have a largest width. Accordingly, the embodiment allows an impact applied to the connection member 200 to be absorbed by the first insulating layer 201, thereby preventing it from being transmitted to the second insulating layer 202 and/or the third insulating layer 203.

In addition, the width of the second insulating layer 202 of the connection member 200 in the horizontal direction can be different from the width of the third insulating layer 203 in the horizontal direction. The width of the second insulating layer 202 in the horizontal direction can be larger than the width of the third insulating layer 203 in the horizontal direction. At this time, the third insulating layer 203 can be a solder resist, and thus, cracks can easily occur due to external impact. In addition, a manufacturing process of the connection member 200 can include a sawing process. The above-described sawing process may be a process for individually separating a plurality of connection members. At this time, if an impact is applied to the third insulating layer 203 in the above-described sawing process, there is a problem that a crack occurs in the third insulating layer 203. Therefore, the embodiment makes it possible to protect the third insulating layer 203 from the impact by making the width of the third insulating layer 203 smaller than the widths of the first insulating layer 201 and the second insulating layer 202.

Specifically, a horizontal distance W1 from a side end of the first insulating layer 201 of the connection member 200 to a side end of the third insulating layer 203 can satisfy a range of 50 µm to 70 µm. If the horizontal distance W1 from the side end of the first insulating layer 201 of the connection member 200 to the side end of the third insulating layer 203 is less than 50 µm, an impact may be applied to the third insulating layer 203 during the sawing process, and thus a crack may occur in the third insulating layer 203. In addition, if the horizontal distance W1 from the side end of the first insulating layer 201 of the connection member 200 to the side end of the third insulating layer 203 exceeds 70 µm, the circuit layer included in the connection member 200 may not be stably protected, or a region where the circuit layer is not disposed in the connection member 200 may increase, and thus the circuit integration may be reduced.

Accordingly, the side surfaces of the first insulating layer 201, the second insulating layer 202, and the third insulating layer 203 of the connection member 200 can have a step from each other. Through this, the step of the side surface of the connection member 200 can come into contact with the insulating layer of the circuit board, thereby increasing the contact area.

At this time, the third insulating layer 203 of the connection member 200 can be attached on the insulating member 180. At this time, the insulating member 180 can have a width different from the horizontal width of the connection member 200. For example, the width of the insulating member 180 can be larger than the width of the insulating member 180 of the connection member 200. Through this, the embodiment can further improve the bonding strength between the connection member 200 and the insulating member 180, and further improve the bonding strength with the insulating layer of the circuit board.

Meanwhile, the connection member 200 may be provided with a circuit pattern. The circuit pattern 206 may include a connection pattern 204 and a through pattern 205. The connection circuit 204 and the via circuit 205 may correspond to the connection electrode and the through electrode of the circuit board, respectively.

Each of the connection pattern 204 and the through pattern 205 of the circuit pattern 206 may have a different size from the connection electrode and the through electrode of the circuit board. For example, the connection pattern 204 and the through pattern 205 of the circuit pattern 206 of the connection member 200 may be finer than the connection electrode and the through electrode of the circuit board.

The connection pattern 204 and the through pattern 205 of the circuit pattern 206 may each include a plurality of metal layers. The plurality of metal layers may include a first metal layer and a second metal layer.

The first metal layer may be a metal layer formed through sputtering. The first metal layer may be a seed layer. The first metal layer may have a one-layer structure, or alternatively, may have a two-layer structure.

When the first metal layer has a one-layer structure, the first metal layer may include only a first layer including at least one of nickel (Ni) and chromium (Cr). In addition, when the first metal layer has a two-layer structure, the first metal layer may further include a second layer containing copper (Cu) on the first layer. Hereinafter, the first metal layer will be described as including a first layer and a second layer. However, the embodiment is not limited thereto.

A first layer of the first metal layer includes at least one of nickel (Ni) and chromium (Cr) formed through a sputtering process. In addition, a second layer of the first metal layer may be formed by sputtering a metal containing copper (Cu) on the first layer of the first metal layer.

The first layer of the first metal layer may have a thickness of 0.01 µm to 0.15 µm. For example, the first layer of the first metal layer may have a thickness of 0.03 µm to 0.14 µm. For example, the first layer of the first metal layer may have a thickness of 0.05 µm to 0.12 µm. If the first layer of the first metal layer is smaller than 0.01 µm, the first metal layer may not function as a seed layer. In addition, if the first layer of the first metal layer is smaller than 0.01 µm, the adhesion between the first metal layer and the second metal layer may not be secured.

In addition, if the thickness of the first layer of the first metal layer is larger than 0.15 µm, a line width and a spacing of the connection pattern 204 of the connection member 200 may increase. For example, if the thickness of the first layer of the first metal layer is larger than 0.15 µm, it may be difficult to micronize the connection pattern 204 of the connection member 200.

The second layer of the first metal layer may have a thickness of 0.1 µm to 0.35 µm. For example, the second layer of the first metal layer may have a thickness of 0.12 µm to 0.34 µm. For example, the second layer of the first metal layer may have a thickness of 0.15 µm to 0.33 µm.

Meanwhile, a total thickness including the first layer and the second layer of the first metal layer may be 0.5 µm or less. Preferably, the total thickness including the first layer and the second layer of the first metal layer may be 0.4 µm or less. More preferably, the total thickness including the first layer and the second layer of the first metal layer may be 0.3 µm or less. If the total thickness including the first layer and the second layer of the first metal layer exceeds 0.5 µm, it may be difficult to miniaturize the connection member 200. Specifically, a process of forming the connection pattern 204 of the connection member 200 includes a seed layer removal process for removing the first metal layer. At this time, as the thickness of the first metal layer increases, an etching amount in the seed layer process increases, and thus miniaturization of the connection pattern 204 of the connection member 200 may be difficult.

The first metal layer of the embodiment is formed by a sputtering process, and the miniaturization of the connection pattern 204 can be possible.

The second metal layer can be an electroplating layer formed by electroplating the first metal layer as a seed layer. The second metal layer can have a thickness in a range of 2 µm to 12 µm. The second metal layer can have a thickness in a range of 3 µm to 11 µm. The second metal layer can have a thickness in a range of 4 µm to 10 µm.

If the thickness of the second metal layer is less than 2 µm, the second metal layer is also etched together in a process of etching the seed layer, and normal implementation of the connection pattern 204 can be difficult. If the thickness of the second metal layer is greater than 12 µm, miniaturization of the connection pattern 204 of the connection member 200 can be difficult.

The thickness of the connection pattern 204 of the connection member 200 as described above may have a thickness in a range of 3 µm to 13 µm. The thickness of the connection pattern 204 of the connection member 200 having the layer structure as described above may have a thickness in a range of 4 µm to 12 µm. The thickness of the connection pattern 204 of the connection member 200 may have a thickness in a range of 5 µm to 11 µm. If the thickness of the connection pattern 204 of the connection member 200 is less than 5 µm, a resistance of the connection pattern 204 may increase, thereby deteriorating the electrical signal characteristics for communication with the first and second semiconductor devices. If the thickness of the connection pattern 204 of the connection member 200 exceeds 11 µm, it may be difficult to implement a fine pattern required for the connection member 200.

Accordingly, the connection pattern 204 may be an ultra-fine pattern. For example, the connection pattern 204 may have a line width of 5 µm or less. For example, the connection pattern 204 may have a line width of 3 µm or less. For example, the connection pattern 204 may have a line width of 2 µm or less. The connection pattern 204 may have a spacing of 5 µm or less. The spacing may mean a spacing between traces of the connection pattern 204 disposed on a same layer. For example, the connection pattern 204 may have a spacing of 3 µm or less. For example, the connection pattern 204 may have a spacing of 2 µm or less.

Preferably, the connection pattern 204 may have a line width of 1 µm to 5 µm. The connection pattern 204 may have a line width of 1.2 µm to 3 µm. The connection pattern 204 may have a line width of 1.5 µm to 2 µm. If the line width of The connection pattern 204 is smaller than 1µm, a resistance of the connection pattern 204 increases, and thus normal communication with a processor chip may be difficult. If the line width of the connection pattern 204 is larger than 5µm, it may be difficult to implement a connection member 200 for connection between multiple processor chips within a limited space. For example, if the line width of The connection pattern 204 is larger than 6µm, it may be difficult to arrange all circuit patterns within a limited space.

Meanwhile, referring to FIG. 8, the first insulating layer 111 of the circuit board may include a first region 112R1, a second region 112R2, and a third region 112R3 in the thickness direction.

The fifth electrode part 170 may be disposed on the first region 112R1 of the first insulating layer 111. The second region 112R2 of the first insulating layer 111 may mean a region that horizontally overlaps with the connection member 200. The second region 112R2 of the first insulating layer 111 may include a cavity C. The third region 112R3 of the first insulating layer 111 may mean a region that horizontally overlaps with the first electrode part 130 and the second electrode part 140.

The first electrode part 130 may be disposed on the pad 210 of the connection member 200. In addition, the second electrode part 140 may be disposed on the connection electrode 143 spaced apart from the pad 210 of the connection member 200 in a direction.

The second region 112R2 and the third region 112R3 of the first insulating layer 111 may include different materials. In this case, an interface between the cavity C of the second region 112R2 and the third region 112R3 may be distinguished.

The second region 112R2 and the third region 112R3 of the first insulating layer 111 may include a same material. In this case, the interface between the cavity C of the second region 112R2 and the third region 112R3 may not be distinguished.

At this time, the pad 210 of the connection member 200 may be manufactured together with the connection member 200 during the manufacturing of the connection member 200. In addition, the connection electrode 143 may be manufactured through a separate process from the pad 210 of the connection member 200. Therefore, the pad 210 of the connection member 200 and the connection electrode 143 may have different thicknesses in the vertical direction.

The thickness of the cavity C may be different from the thickness of the connection member 200. Through this, an upper surface of the second region 112R2 of the first insulating layer 111 and the connection member 200 may have a height difference H1.

For example, the thickness of the cavity C may be smaller than the thickness of the connection member 200. Accordingly, the upper surface of the second region 112R2 of the first insulating layer 111 may be positioned lower than the upper surface of the connection member 200 by a height difference H1.

Accordingly, the upper surface of the first insulating layer 111 may have a step.

For example, the upper surface of the first insulating layer 111 may include a first upper surface 110T1 that vertically overlaps the connection member 200. In addition, the upper surface of the first insulating layer 111 may include a second upper surface 110T2 that does not vertically overlap the connection member 200. In addition, the first upper surface 110T1 and the second upper surface 110T2 of the first insulating layer 111 may have a step. For example, the first upper surface 110T1 of the first insulating layer 111 may be positioned higher than the second upper surface 110T2. For example, the first insulating layer 111 may include a convex portion corresponding to the first upper surface 110T1.

Meanwhile, a first electrode part 130 and a second electrode part 140 may be disposed on the first insulating layer 111. In addition, an upper surface 130T of the first electrode part 130 and an upper surface 140T of the second electrode part 140 may have different heights. For example, the upper surface 130T of the first electrode part 130 and the upper surface 140T of the second electrode part 140 may have a step H2. For example, the upper surface 130T of the first electrode part 130 may be positioned higher than the upper surface 140T of the second electrode part 140 by the step H2.

In addition, an upper surface of the second insulating layer 112 of the circuit board may also have a step.

For example, the upper surface of the second insulating layer 112 may include a first upper surface 112T1 that vertically overlaps the connection member 200. In addition, the upper surface of the second insulating layer 112 may include a second upper surface 112T2 that does not vertically overlap the connection member 200. In addition, the first upper surface 112T1 and the second upper surface 112T2 of the second insulating layer 111 may have a step. For example, the first upper surface 112T1 of the second insulating layer 112 may be positioned higher than the second upper surface 112T2. For example, the second insulating layer 112 may include a convex portion corresponding to the first upper surface 112T1.

In addition, the upper surfaces of each of the first protruding electrode 135 and the second protruding electrode 145 may have different heights. For example, the upper surface 135T of the first protruding electrode 135 may have a step difference from the upper surface 145T of the second protruding electrode 145. For example, the upper surface 135T of the first protruding electrode 135 may be positioned higher than the upper surface 145T of the second protruding electrode 145.

Accordingly, since the first protruding electrode 135 and the second protruding electrode 145 have a step, arrangement positions of the first semiconductor device and the second semiconductor device can be recognized, and through this, the first and second semiconductor devices can be mounted at more accurate positions. Furthermore, the embodiment can adjust a volume of the conductive bonding member, such as solder, which is respectively disposed on the first protruding electrode 135 and the second protruding electrode 145 differently from each other. Therefore, the embodiment can position the protruding electrode on which the conductive bonding member requiring a larger volume is disposed lower than other protruding electrodes. This can be possible by adjusting the difference in thickness of the cavity C and the connection member 200. Through this, the embodiment can enable the semiconductor device to be more stably coupled to the circuit board. Therefore, the embodiment can enable the semiconductor device to operate smoothly, and further improve the operating characteristics of electronic products and/or servers to which the semiconductor package is applied.

Meanwhile, referring to FIG. 9, a plurality of interfaces may exist between the first insulating layer 111 of the circuit board and the connection member 200.

For example, the interface may include a first interface IS1 between the first insulating layer 111 of the circuit board and the first insulating layer 201 of the connection member 200. The interface may include a second interface IS2 between the first insulating layer 111 of the circuit board and the second insulating layer 202 of the connection member 200. The interface may include a third interface IS3 between the first insulating layer 111 of the circuit board and the third insulating layer 201 of the connection member 200. In addition, the first to third interfaces IS1, IS2, and IS3 may not be aligned in a vertical direction and may have a step.

Meanwhile, the second insulating layer 202 of the connection member 200 may include the same insulating material as the first insulating layer 111 of the circuit board. In this case, it may be difficult to distinguish the second interface IS2.

At this time, a filler 202F included in the second insulating layer 202 of the connection member 200 may have different characteristics from a filler 111F included in the first insulating layer 111 of the circuit board.

For example, the electrode parts disposed in the first insulating layer 111 may not require a fine pattern compared to the electrode parts disposed in the connection member 200. Therefore, the filler 111F included in the first insulating layer 111 may have a relatively large diameter in order to secure the rigidity of the circuit board. For example, the filler 111F included in the first insulating layer 111 may have a diameter in a range of 1 µm to 5 µm.

In contrast, the second insulating layer 202 of the connection member 200 must be capable of forming a fine electrode part through a sputtering process. Therefore, the filler 202F included in the second insulating layer 202 of the connection member 200 may have a relatively small diameter. For example, the filler 202F included in the second insulating layer 202 of the connection member 200 may have a diameter in a range of 0.2 µm to 0.9 µm. Therefore, the embodiment can distinguish the interface between the second insulating layer 202 of the connection member 200 and the first insulating layer 111 of the circuit board through the diameter of the filler even if the second insulating layer 202 of the connection member 200 includes the same insulating material.

Meanwhile, referring to FIG. 10, each of the first protruding electrode 135 and the second protruding electrode 145 may include a plurality of metal layers.

For example, the first protruding electrode 135 may include a first metal layer 135-1 disposed on the first electrode part 130. In addition, the first protruding electrode 135 may include a second metal layer 135-2 disposed on the first metal layer 135-1. At this time, the first metal layer 135-1 and the second metal layer 135-2 may include different metal materials.

Preferably, the first metal layer 135-1 may include nickel. In addition, the second metal layer 135-2 may include copper. The first metal layer 135-1 can improve the bonding strength between the second metal layer 135-2 and the first electrode part 130. For example, when the second metal layer 135-2 is directly disposed on the first electrode part 130, oxidation of the first electrode part 130 may occur, which may reduce the bonding strength between the first electrode part 130 and the second metal layer 135-2. Therefore, the first metal layer 135-1 can function to prevent oxidation of the first electrode part 130 while improving the bonding strength between the second metal layer 135-2 and the first electrode part 130. In addition, the first metal layer 135-1 can solve the problem of the first protruding electrode 135 being peeled off from the first electrode part 130 due to contraction and expansion of the second insulating layer 112 caused by thermal stress.

Specifically, when the first metal layer 135-1 contains nickel, the adhesion between the first electrode part 130 and the second metal layer 135-2 can be improved. In addition, when electrically connecting the first electrode part 130 to the first electrode part 130 is formed later through a material such as solder, the solder can diffuse into the first electrode part 130 to form an inter-metallic compound, and the inter-metallic compound has a problem of poor mechanical and electrical reliability. In particular, when the second metal layer 135-2 is made of copper, the problem of forming the inter-metallic compound may be further aggravated. However, when the nickel is disposed, the diffusion of solder can be prevented, thereby preventing the formation of the inter-metallic compound, thereby improving the electrical and mechanical reliability of the semiconductor package.

At this time, the first electrode part 130 may include a crevice 130C. For example, the upper surface of the first electrode part 130 may include a crevice 130C that vertically overlaps the first protruding electrode 135 and is concave toward the lower surface of the first electrode part 130. The crevice 130C may be filled with the first metal layer 135-1 of the first protruding electrode 135. Through this, a contact area between the first electrode part 130 and the first protruding electrode 135 can be increased, and thus the bonding strength can be further improved.

In addition, the second protruding electrode 145 may also include a first metal layer 145-1 and a second metal layer 145-2. The first metal layer 145-1 of the second protruding electrode 145 may be disposed on the second electrode part 140. In addition, the second metal layer 145-2 of the second protruding electrode 145 may be disposed on the first metal layer 145-1. A crevice 140C may be provided at the upper surface of the second electrode part 140, and the first metal layer 145-1 of the second protruding electrode 145 may be provided to fill the crevice 140C of the second electrode part 140.

Meanwhile, referring to FIG. 11, a thickness of the cavity C may be different from a thickness of the connection member 200. Accordingly, the upper surface of the second region 112R2 of the first insulating layer 111 and the connection member 200 may have a height difference H1.

For example, the thickness of the cavity C may be greater than the thickness of the connection member 200. Accordingly, the upper surface of the second region 112R2 of the first insulating layer 111 may be positioned higher than the upper surface of the connection member 200 by the height difference H1.

Accordingly, the upper surface of the first insulating layer 111 may have a step.

For example, the upper surface of the first insulating layer 111 may include a first upper surface 110T1 that vertically overlaps the connection member 200. In addition, the upper surface of the first insulating layer 111 may include a second upper surface 110T2 that does not vertically overlap with the connection member 200. In addition, the first upper surface 110T1 and the second upper surface 110T2 of the first insulating layer 111 may have a step. For example, the first upper surface 110T1 of the first insulating layer 111 may be positioned lower than the second upper surface 110T2. For example, the first insulating layer 111 may include a concave portion corresponding to the first upper surface 110T1.

Meanwhile, a first electrode part 130 and a second electrode part 140 may be disposed on the first insulating layer 111. In addition, the upper surface 130T of the first electrode part 130 and the upper surface 140T of the second electrode part 140 may have different heights. For example, the upper surface 130T of the first electrode part 130 and the upper surface 140T of the second electrode part 140 may have a step H2. For example, the upper surface 130T of the first electrode part 130 may be positioned lower than the upper surface 140T of the second electrode part 140 by the step H2.

In addition, the upper surface of the second insulating layer 112 of the circuit board may also have a step.

For example, the upper surface of the second insulating layer 112 may include a first upper surface 112T1 that vertically overlaps the connection member 200. In addition, the upper surface of the second insulating layer 112 may include a second upper surface 112T2 that does not vertically overlap with the connection member 200. In addition, the first upper surface 112T1 and the second upper surface 112T2 of the second insulating layer 111 may have a step. For example, the first upper surface 112T1 of the second insulating layer 112 may be positioned lower than the second upper surface 112T2. For example, the second insulating layer 112 may include a concave portion corresponding to the first upper surface 112T1.

In addition, the upper surfaces of each of the first protruding electrode 135 and the second protruding electrode 145 may have different heights. For example, the upper surface 135T of the first protruding electrode 135 may have a step difference from the upper surface 145T of the second protruding electrode 145. For example, the upper surface 135T of the first protruding electrode 135 may be positioned lower than the upper surface 145T of the second protruding electrode 145.

Meanwhile, referring to FIG. 12, the thickness of the cavity C may be the same as the thickness of the connection member 200. Accordingly, the upper surface of the second region 112R2 of the first insulating layer 111 and the connection member 200 may be positioned on a same plane.

Accordingly, the upper surface of the first insulating layer 111 may be entirely flat.

Meanwhile, the first electrode part 130 and the second electrode part 140 may be disposed on the first insulating layer 111. In addition, the upper surface 130T of the first electrode part 130 and the upper surface 140T of the second electrode part 140 may also have a same height. For example, the upper surface 130T of the first electrode part 130 and the upper surface 140T of the second electrode part 140 may be positioned on a same plane.

In addition, the upper surface of the second insulating layer 112 of the circuit board may also be entirely flat.

In addition, the upper surfaces of each of the first protruding electrode 135 and the second protruding electrode 145 may have a same height.

On the other hand, when the circuit board having the above-described characteristics of the invention is used in an IT device or home appliance such as a smart phone, a server computer, a TV, and the like, functions such as signal transmission or power supply can be stably performed. For example, when a circuit board having the features of the present invention performs a semiconductor package function, the circuit board can function to safely protect the semiconductor chip from external moisture or contaminants, or alternatively, it is possible to solve problems of leakage current, electrical short circuit between terminals, and electrical opening of terminals supplied to the semiconductor chip. In addition, when the function of signal transmission is in charge, it is possible to solve the noise problem. Through this, the circuit board having the above-described characteristics of the invention can maintain the stable function of the IT device or home appliance, so that the entire product and the circuit board to which the present invention is applied can achieve functional unity or technical interlocking with each other.

When the circuit board having the characteristics of the invention described above is used in a transport device such as a vehicle, it is possible to solve the problem of distortion of a signal transmitted to the transport device, or alternatively, the safety of the transport device can be further improved by safely protecting the semiconductor chip that controls the transport device from the outside and solving the problem of leakage current or electrical short between terminals or the electrical opening of the terminal supplied to the semiconductor chip. Accordingly, the transportation device and the circuit board to which the present invention is applied can achieve functional integrity or technical interlocking with each other.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A circuit board comprising:
a build-up insulating layer;
a connection member embedded in the build-up insulating layer; and
an insulating member disposed on one surface of the connection member,
wherein the connection member includes:
a first insulating layer; and
a second insulating layer disposed on the first insulating layer,
wherein the first insulating layer, the second insulating layer, and the insulating member includes different insulating materials, and
wherein a side surface of the first insulating layer, a side surface of the second insulating layer, and a side surface of the insulating member have a step.

2. The circuit board of claim 1, wherein the connection member further includes a third insulating layer disposed on the second insulating layer, and
wherein the third insulating layer includes an insulating material different from that of at least one of the first and second insulating layers, and
wherein a side surface of the third insulating layer has a step from a side surface of the first insulating layer, a side surface of the second insulating layer, and a side surface of the insulating member.

3. The circuit board of claim 1, wherein a width in a horizontal direction of the first insulating layer of the connection member is greater than a width in the horizontal direction of the second insulating layer.

4. The circuit board of claim 3, wherein a width in the horizontal direction of the insulating member is greater than a width in the horizontal direction of each of the first insulating layer and the second insulating layer.

5. The circuit board of any one of claims 1 to 4, wherein the first insulating layer of the connection member includes a polyimide.

6. The circuit board of any one of claims 1 to 4, wherein the second insulating layer of the connection member includes a resin layer including a filler.

7. The circuit board of claim 6, wherein the build-up insulating layer includes an insulating material different from that of the second insulating layer of the connection member.

8. The circuit board of claim 6, wherein the build-up insulating layer includes a same insulating material as the second insulating layer of the connection member, and
wherein a diameter of a filler provided in the build-up insulating layer is different from a diameter of a filler provided in the second insulating layer of the connection member.

9. The circuit board of claim 8, wherein the diameter of the filler provided in the build-up insulating layer is greater than the diameter of the filler provided in the second insulating layer of the connection member.

10. The circuit board of any one of claims 1 to 4, wherein a horizontal distance from an outermost end to an innermost end of the connection member satisfies a range of 50 µm to 70 µm.
